(19) Europäisches Patentamt
European Patent Office
Office européen des brevets

(11) EP 2 301 020 B1

(12) EUROPEAN PATENT SPECIFICATION

(45) Date of publication and mention
of the grant of the patent:
02.01.2013 Bulletin 2013/01

(51) Int Cl.:
*G10L 19/02* (2013.01)   *G10L 19/04* (2013.01)

(21) Application number: 09776763.6

(22) Date of filing: 17.06.2009

(86) International application number:
PCT/EP2009/004374

(87) International publication number:
WO 2010/003532 (14.01.2010 Gazette 2010/02)

(54) **APPARATUS AND METHOD FOR ENCODING/DECODING AN AUDIO SIGNAL USING AN ALIASING SWITCH SCHEME**

VORRICHTUNG UND VERFAHREN ZUR KODIERUNG/DEKODIERUNG EINES TONSIGNALS ANHAND EINES ALIASING-SCHALTSCHEMAS

DISPOSITIF ET PROCÉDÉ D'ENCODAGE/DE DÉCODAGE D'UN SIGNAL AUDIO UTILISANT UNE MÉTHODE DE COMMUTATION À REPLIEMENT

(84) Designated Contracting States:
AT BE BG CH CY CZ DE DK EE ES FI FR GB GR
HR HU IE IS IT LI LT LU LV MC MK MT NL NO PL
PT RO SE SI SK TR

(30) Priority: 11.07.2008 US 79852

(43) Date of publication of application:
30.03.2011 Bulletin 2011/13

(73) Proprietor: Fraunhofer-Gesellschaft zur
Förderung der
angewandten Forschung e.V.
80686 München (DE)

(72) Inventors:
• FUCHS, Guillaume
  91058 Erlangen (DE)
• LECOMTE, Jérémie
  90489 Nürnberg (DE)
• BAYER, Stefan
  90425 Nürnberg (DE)
• GEIGER, Ralf
  90409 Nürnberg (DE)
• MULTRUS, Markus
  90469 Nürnberg (DE)
• SCHULLER, Gerald
  99089 Erfurt (DE)
• HIRSCHFELD, Jens
  36266 Heringen (DE)

(74) Representative: Burger, Markus et al
Schoppe Zimmermann
Stöckeler Zinkler & Partner
Postfach 246
82043 Pullach (DE)

(56) References cited:
EP-A2- 1 278 184        WO-A1-2004/082288
WO-A2-2008/071353

• SANG-WOOK SHIN; CHANG-HEON LEE; HYEN-O OH; HONG-GOO KANG ED - ALI A M; HUDSON R E; KUNG YAO: "Designing a unified speech/audio codec by adopting a single channel harmonic source separation module" ACOUSTICS, SPEECH AND SIGNAL PROCESSING, 2008. ICASSP 2008. IEEE INTERNATIONAL CONFERENCE ON, IEEE, PISCATAWAY, NJ, USA, 31 March 2008 (2008-03-31), pages 185-188, XP031250519

• NEUENDORF M; GOURNAY P; MULTRUS M; LECOMTE J; BESSETTE B; GEIGER R; BAYER S; FUCHS G; HILPERT J; RETTELBACH N; SALAMI R; SCHULLER: "Unified speech and audio coding scheme for high quality at low bitrates" ACOUSTICS, SPEECH AND SIGNAL PROCESSING, 2009. ICASSP 2009. IEEE INTERNATIONAL CONFERENCE ON, IEEE, PISCATAWAY, NJ, USA, 19 April 2009 (2009-04-19), pages 1-4, XP031459151

**Description**

The present invention is related to audio coding and, particularly, to low bit rate audio coding schemes.

In the art, frequency domain coding schemes such as MP3 or AAC are known. These frequency-domain encoders are based on a time-domain/frequency-domain conversion, a subsequent quantization stage, in which the quantization error is controlled using information from a psychoacoustic module, and an encoding stage, in which the quantized spectral coefficients and corresponding side information are entropy-encoded using code tables.

On the other hand there are encoders that are very well suited to speech processing such as the AMR-WB+ as described in 3GPP TS 26.290. Such speech coding schemes perform a Linear Predictive filtering of a time-domain signal. Such a LP filtering is derived from a Linear Prediction analysis of the input time-domain signal. The resulting LP filter coefficients are then quantized/coded and transmitted as side information. The process is known as Linear Prediction Coding (LPC). At the output of the filter, the prediction residual signal or prediction error signal which is also known as the excitation signal is encoded using the analysis-by-synthesis stages of the ACELP encoder or, alternatively, is encoded using a transform encoder, which uses a Fourier transform with an overlap. The decision between the ACELP coding and the Transform Coded excitation coding which is also called TCX coding is done using a closed loop or an open loop algorithm.

Frequency-domain audio coding schemes such as the high efficiency-AAC encoding scheme, which combines an AAC coding scheme and a spectral band replication technique can also be combined with a joint stereo or a multi-channel coding tool which is known under the term "MPEG surround".

On the other hand, speech encoders such as the AMR-WB+ also have a high frequency enhancement stage and a stereo functionality.

Frequency-domain coding schemes are advantageous in that they show a high quality at low bitrates for music signals. Problematic, however, is the quality of speech signals at low bitrates.

Speech coding schemes show a high quality for speech signals even at low bitrates, but show a poor quality for music signals at low bitrates.

Frequency-domain coding schemes often make use of the so-called MDCT (MDCT= modified discrete Cosine transform). The MDCT has been initially described in J. Princen, A. Bradley, "Analysis/Synthesis Filter Bank Design Based on Time Domain Aliasing Cancellation", IEEE Trans. ASSP, ASSP-34(5):1153-1161, 1986. The MDCT or MDCT filter bank is widely used in modern and efficient audio coders. This kind of signal processing provides the following advantages:

Smooth cross-fade between processing blocks:

Even if the signal in each processing block is altered differently (e.g. due to quantization of spectral coefficients), no blocking artifacts due to abrupt transitions from block to block occur because of the windowed overlap/add operation.

Critical sampling: The number of spectral values at the output of the filterbank is equal to the number of time domain input values at its input and additional overhead values have to be transmitted.

The MDCT filterbank provides a high frequency selectivity and coding gain.

Those great properties are achieved by utilizing the technique of time domain aliasing cancellation. The time domain aliasing cancellation is done at the synthesis by overlap-adding two adjacent windowed signals. If no quantization is applied between the analysis and the synthesis stages of the MDCT, a perfect reconstruction of the original signal is obtained. However, the MDCT is used for coding schemes, which are specifically adapted for music signals. Such frequency-domain coding schemes have, as stated before, reduced quality at low bit rates or speech signals, while specifically adapted speech coders have a higher quality at comparable bit rates or even have significantly lower bit rates for the same quality compared to frequency-domain coding schemes.

Speech coding techniques such as the so-called AMR-WB+ codec as defined in "Extended Adaptive Multi-Rate - Wideband (AMR-WB+) codec", 3GPP TS 26.290 V6.3.0, 2005-06, Technical Specification, do not apply the MDCT and, therefore, can not take any advantage from the excellent properties of the MDCT which, specifically, rely in a critically sampled processing on the one hand and a crossover from one block to the other on the other hand. Therefore, the crossover from one block to the other obtained by the MDCT without any penalty with respect to bit rate and, therefore, the critical sampling property of MDCT has not yet been obtained in speech coders.

When one would combine speech coders and audio coders within a single hybrid coding scheme, there is still the problem of how to obtain a switch from one coding mode to the other coding mode at a low bit rate and a high quality.

Document WO 2008/071353 A2 discloses another example of an apparatus for encoding/decoding audio data.

It is an object of the present invention to provide an improved encoding/decoding concept.

This object is achieved by an apparatus for encoding an audio signal in accordance with claim 1, an apparatus for decoding an encoded audio signal in accordance with claim 8, an encoded audio signal in accordance with claim 14, a method for encoding an audio signal in accordance with claim 15, a method of decoding an encoded audio signal in accordance with claim 16 or a computer program product in accordance with claim 17.

An aspect of the present invention is that a hybrid coding scheme is applied, in which a first coding mode specifically adapted for certain signals and operating in one domain is applied, and in which a further coding mode specifically adapted for other signals and operation in a different domain are used together. In this coding/decoding concept, a critically sampled switch from one coding mode to the other coding mode is made possible in that, on the encoder side, the same block of audio samples which has been generated by one windowing operation is processed differently. Specifically, an aliasing portion of the block of the audio signal is processed by transforming the sub-block associated with the aliasing portion of the window from one domain into the other domain subsequent to windowing this sub-block, where a different sub-block obtained by the same windowing operation is transformed from one domain into the other domain before windowing this sub-block using an analysis window.

The processed first sub-block and the processed second sub-block are, subsequently, transformed into a further domain using the same block transform rule to obtain a converted first block of the audio signal which can then be further processed using any of the well-known data compression algorithms such as quantizing, entropy encoding and so on.

On the decoder-side, this block is again processed differently based on whether the aliasing portion of the block is processed or the other further portion of the block is processed. The aliasing portion is transformed into a target domain before performing a synthesis windowing while the further portion is subject to a synthesis windowing before performing the transforming to the target domain. Additionally, in order to obtain the critically sampling property, a time domain aliasing cancellation is performed, in which the windowed aliasing portion and a windowed aliasing portion of an encoded other block of the audio data are combined subsequent to a transform of the aliasing portion of the encoded audio signal block into the target domain so that a decoded audio signal corresponding to the aliasing portion of the first block is obtained. In view of that, there do exist two sub-blocks/portions in a window. One portion/sub-block (aliasing sub-block) has aliasing components, which overlap a second block coded in a different domain, and a second sub-block/portion (further sub-block), which may or may not have aliasing components which overlaps the second block or a block different from the second block.

Preferably, the aliasing introduced into certain portions which correspond to each other, but which are encoded in different domains is advantageously used for obtaining a critically sampled switch from one coding mode to the other coding mode by differently processing the aliasing portion and the further portion within one and the same windowed block of audio sample.

This is in contrast to prior art processing based on analysis windows and synthesis windows, since, up to now, a complete data block obtained by applying an analysis window has been subjected to the same processing. In accordance with the present invention, however, the aliasing portion of the windowed block is processed differently compared to the further portion of this block.

The further portion can comprise a non-aliasing portion occurring, when specific start/stop windows are used. Alternatively, the further portion can comprise an aliasing portion overlapping with a portion of the result of an adjacent windowing process. Then, the further (aliasing) portion overlaps with an aliasing portion of a neighboring frame processed in the same domain compared to the further (aliasing) portion of the current frame, and the aliasing portion overlaps with an aliasing portion of a neighboring frame processed in a different domain compared to the aliasing portion of the current frame.

Depending on the implementation, the further portion and the aliasing portion together form the complete result of an application of a window function to a block of audio samples. The further portion can be completely aliasing free or can be completely aliasing or can include an aliasing sub-portion and an aliasing free sub-portion. Furthermore, the order of theses sub-portions and the order of the aliasing portion and the further portion can be arbitrarily selected.

In a preferred embodiment of the switched audio coding scheme, adjacent segments of the input signal could be processed in two different domains. For example, AAC computes a MDCT in the signal domain, and the MTPC(Sean A. Ramprashad, "The Multimode Transform predictive Coding Paradigm", IEEE Transaction on Speech and Audio Processing, Vol. 11, No. 2, March 2003) computes a MDCT in the LPC residual domain. It could be problematic especially when the overlapped regions have time-domain aliasing components due to the use of a MDCT. Indeed, the time-domain aliasing can not be cancelled in the transitions where going from one coder to another, because they were produced in two different domains. One solution is to make the transitions with aliasing-free cross-fade windowed signals. The switched coder is then no more critically sampled and produces an overhead of information. Embodiments permit to maintain the critically sampling advantage by canceling time-domain aliasing components computed by operating in two different domains.

In a preferred embodiment of the present invention, two switches are provided in a sequential order, where a first switch decides between coding in the spectral domain using a frequency-domain encoder and coding in the LPC-domain, i.e., processing the signal at the output of an LPC analysis stage. The second switch is provided for switching in the LPC-domain in order to encode the LPC-domain signal either in the LPC-domain such as using an ACELP coder or coding the LPC-domain signal in an LPC-spectral domain, which requires a converter for converting the LPC-domain signal into an LPC-spectral domain, which is different from a spectral domain, since the LPC-spectral domain shows the spectrum of an LPC filtered signal rather than the spectrum of the time-domain signal.

The first switch decides between two processing branches, where one branch is mainly motivated by a sink model and/or a psycho acoustic model, i.e. by auditory masking, and the other one is mainly motivated by a source model and by segmental SNR calculations. Exemplarily, one branch has a frequency domain encoder and the other branch has an LPC-based encoder such as a speech coder. The source model is usually the speech processing and therefore LPC is commonly used.

The second switch again decides between two processing branches, but in a domain different from the "outer" first branch domain. Again one "inner" branch is mainly motivated by a source model or by SNR calculations, and the other "inner" branch can be motivated by a sink model and/or a psycho acoustic model, i.e. by masking or at least includes frequency/spectral domain coding aspects. Exemplarily, one "inner" branch has a frequency domain encoder/spectral converter and the other branch has an encoder coding on the other domain such as the LPC domain, wherein this encoder is for example an CELP or ACELP quantizer/scaler processing an input signal without a spectral conversion.

A further preferred embodiment is an audio encoder comprising a first information sink oriented encoding branch such as a spectral domain encoding branch, a second information source or SNR oriented encoding branch such as an LPC-domain encoding branch, and a switch for switching between the first encoding branch and the second encoding branch, wherein the second encoding branch comprises a converter into a specific domain different from the time domain such as an LPC analysis stage generating an excitation signal, and wherein the second encoding branch furthermore comprises a specific domain such as LPC domain processing branch and a specific spectral domain such as LPC spectral domain processing branch, and an additional switch for switching between the specific domain coding branch and the specific spectral domain coding branch.

A further embodiment of the invention is an audio decoder comprising a first domain such as a spectral domain decoding branch, a second domain such as an LPC domain decoding branch for decoding a signal such as an excitation signal in the second domain, and a third domain such as an LPC-spectral decoder branch for decoding a signal such as an excitation signal in a third domain such as an LPC spectral domain, wherein the third domain is obtained by performing a frequency conversion from the second domain wherein a first switch for the second domain signal and the third domain signal is provided, and wherein a second switch for switching between the first domain decoder and the decoder for the second domain or the third domain is provided.

Preferred embodiments of the present invention are subsequently described with respect to the attached drawings, in which:

Fig. 1A    is a schematic representation of a preferred apparatus or method for encoding an audio signal;

Fig. 1B    is a schematic representation of the transition from MDCT-TCX to AAC;

Fig. 1C    is a schematic representation of a transition from AAC to MDCT-TCX;

Fig. 1D    is an illustration of a preferred embodiment of the inventive concept as a flow chart;

Fig. 2    is a schematic representation for illustrating four different domains and their relations, which occur in embodiments of the invention;

Fig. 3A    is a scheme illustrating an inventive apparatus/method for decoding an audio signal;

Fig. 3B    is a further illustration of decoding schemes in accordance with embodiments of the present invention;

Fig. 4A    illustrates details of aliasing-transforms such as the MDCT applicable in both encoding modes;

Fig. 4B    illustrates window functions comparable to the window function in Fig. 4A, but with an aliasing portion and a non-aliasing portion;

Fig. 5    is a schematic representation of an encoder and a decoder in one coding mode such as the AAC-MDCT coding mode;

Fig. 6    is a representation of an encoder and a decoder applying MDCT in a different domain such as the LPC domain in the context of TCX encoding in AMR-WB+;

Fig. 7    is a specific sequence of windows for transitions between AAC and AMR-WB+;

Fig. 8A    is a representation of a preferred embodiment for an encoder and a decoder in the context of switching from the TCX mode to the AAC mode;

Fig. 8B    is a preferred embodiment for illustrating an encoder and a decoder for a transition from AAC to TCX;

Fig. 9A    is a block diagram of a preferred hybrid switched coding scheme, in which the present invention is applied;

Fig. 9B    is a flow chart illustrating the process performed in the controller of Fig. 9A;

Fig. 10A    is a preferred embodiment of a decoder in a hybrid switched coding scheme;

Fig. 10B    is a flow chart for illustrating the procedure performed in the transition controller of Fig. 10A;

Fig. 11A    illustrates a preferred embodiment of an encoder in which the present invention is preferably applied; and

Fig. 11B    illustrates a preferred decoder, in which the present invention is preferably applied.

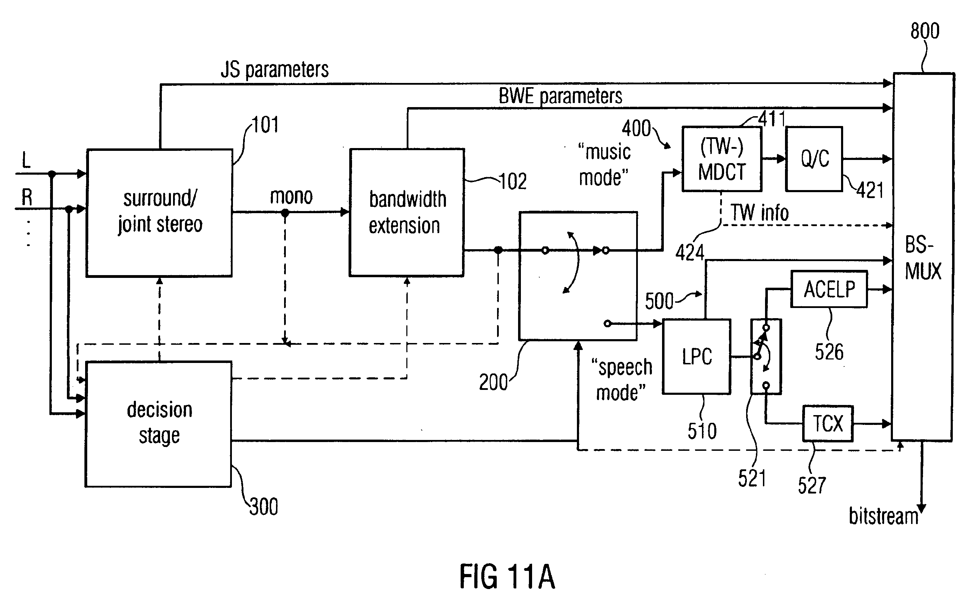

Fig. 11A illustrates an embodiment of the invention having two cascaded switches. A mono signal, a stereo signal or a multi-channel signal is input into a switch 200. The switch 200 is controlled by a decision stage 300. The decision stage receives, as an input, a signal input into block 200. Alternatively, the decision stage 300 may also receive a side information which is included in the mono signal, the stereo signal or the multi-channel signal or is at least associated to such a signal, where information is existing, which was, for example, generated when originally producing the mono signal, the stereo signal or the multi-channel signal.

The decision stage 300 actuates the switch 200 in order to feed a signal either in a frequency encoding portion 400 illustrated at an upper branch of Fig. 11A or an LPC-domain encoding portion 500 illustrated at a lower branch in Fig. 11A. A key element of the frequency domain encoding branch is a spectral conversion block 411 which is operative to convert a common preprocessing stage output signal (as discussed later on) into a spectral domain. The spectral conversion block may include an MDCT algorithm, a QMF, an FFT algorithm, a Wavelet analysis or a filterbank such as a critically sampled filterbank having a certain number of filterbank channels, where the sub-band signals in this filterbank may be real valued signals or complex valued signals. The output of the spectral conversion block 411 is encoded using a spectral audio encoder 421, which may include processing blocks as known from the AAC coding scheme.

Generally, the processing in branch 400 is a processing in a perception based model or information sink model. Thus, this branch models the human auditory system receiving sound. Contrary thereto, the processing in branch 500 is to generate a signal in the excitation, residual or LPC domain. Generally, the processing in branch 500 is a processing in a speech model or an information generation model. For speech signals, this model is a model of the human speech/sound generation system generating sound. If, however, a sound from a different source requiring a different sound generation model is to be encoded, then the processing in branch 500 may be different.

In the lower encoding branch 500, a key element is an LPC device 510, which outputs an LPC information which is used for controlling the characteristics of an LPC filter. This LPC information is transmitted to a decoder. The LPC stage 510 output signal is an LPC-domain signal which consists of an excitation signal and/or a weighted signal.

The LPC device generally outputs an LPC domain signal, which can be any signal in the LPC domain such as an excitation signal or a weighted (TCX) signal or any other signal, which has been generated by applying LPC filter coefficients to an audio signal. Furthermore, an LPC device can also determine these coefficients and can also quantize/encode these coefficients.

The decision in the decision stage can be signal-adaptive so that the decision stage performs a music/speech discrimination and controls the switch 200 in such a way that music signals are input into the upper branch 400, and speech signals are input into the lower branch 500. In one embodiment, the decision stage is feeding its decision information into an output bit stream so that a decoder can use this decision information in order to perform the correct decoding operations.

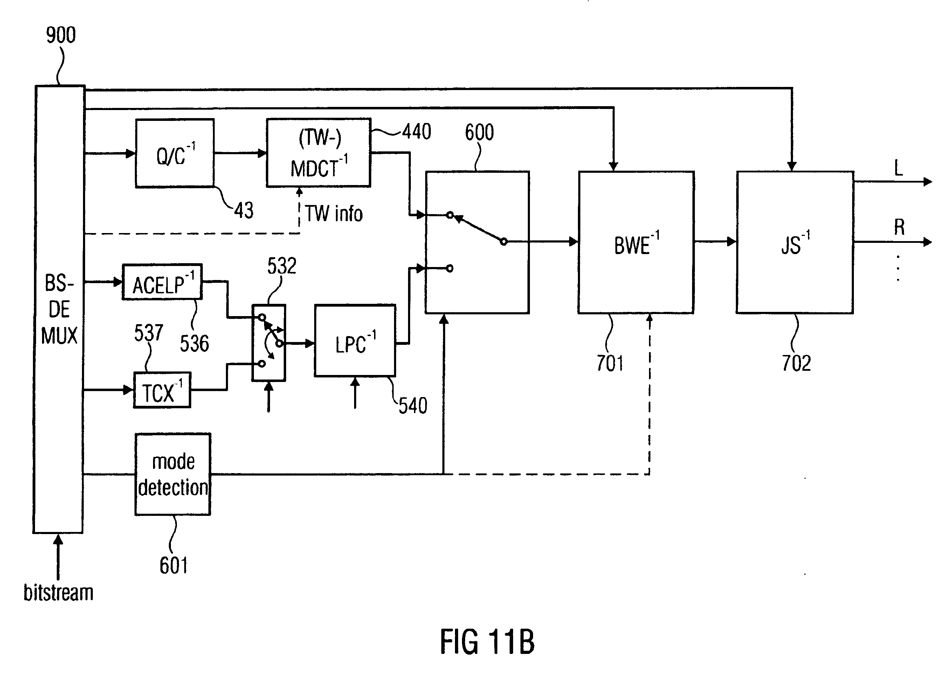

Such a decoder is illustrated in Fig. 11B. The signal output by the spectral audio encoder 421 is, after transmission, input into a spectral audio decoder 431. The output of the spectral audio decoder 431 is input into a time-domain converter 440. Analogously, the output of the LPC domain encoding branch 500 of Fig. 11A received on the decoder side and processed by elements 536 and 537 for obtaining an LPC excitation signal. The LPC excitation signal is input into an LPC synthesis stage 540, which receives, as a further input, the LPC information generated by the corresponding LPC analysis stage 510. The output of the time-domain converter 440 and/or the output of the LPC synthesis stage 540 are input into a switch 600. The switch 600 is controlled via a switch control signal which was, for example, generated by the decision stage 300, or which was externally provided such as by a creator of the original mono signal, stereo signal or multi-channel signal. The output of the switch 600 is a complete mono signal, stereo signal or multi-channel signal.

The input signal into the switch 200 and the decision stage 300 can be a mono signal, a stereo signal, a multi-channel signal or generally an audio signal. Depending on the decision which can be derived from the switch 200 input signal or from any external source such as a producer of the original audio signal underlying the signal input into stage 200, the switch switches between the frequency encoding branch 400 and the LPC encoding branch 500. The frequency encoding branch 400 comprises a spectral conversion stage 411 and a subsequently connected quantizing/coding stage 421. The quantizing/coding stage can include any of the functionalities as known from modern frequency-domain encoders such as the AAC encoder. Furthermore, the quantization operation in the quantizing/coding stage 421 can be controlled via a psychoacoustic module which generates psychoacoustic information such as a psychoacoustic masking threshold over the frequency, where this information is input into the stage 421.

In the LPC encoding branch, the switch output signal is processed via an LPC analysis stage 510 generating LPC side info and an LPC-domain signal. The excitation encoder comprises an additional switch 521 for switching the further processing of the LPC-domain signal between a quantization/coding operation 526 in the LPC-domain or a quantization/coding stage 527, which is processing values in the LPC-spectral domain. To this end, a spectral converter 527 is provided. The switch 521 is controlled in an open loop fashion or a closed loop fashion depending on specific settings as, for example, described in the AMR-WB+ technical specification.

For the closed loop control mode, the encoder additionally includes an inverse quantizer/coder for the LPC domain signal, an inverse quantizer/coder for the LPC spectral domain signal and an inverse spectral converter for the output of the inverse quantizer/coder. Both encoded and again decoded signals in the processing branches of the second encoding branch are input into a switch control device. In the switch control device, these two output signals are compared to each other and/or to a target function or a target function is calculated which may be based on a comparison of the distortion in both signals so that the signal having the lower distortion is used for deciding, which position the switch 521 should take. Alternatively, in case both branches provide non-constant bit rates, the branch providing the lower bit rate might be selected even when the signal to noise ratio of this branch is lower than the signal to noise ratio of the other branch. Alternatively, the target function could use, as an input, the signal to noise ratio of each signal and a bit rate of each signal and/or additional criteria in order to find the best decision for a specific goal. If, for example, the goal is such that the bit rate should be as low as possible, then the target function would heavily rely on the bit rate of the two signals output by the inverse quantizer/coder and the inverse spectral converter. However, when the main goal is to have the best quality for a certain bit rate, then the switch control might, for example, discard each signal which is above the allowed bit rate and when both signals are below the allowed bit rate, the switch control would select the signal having the better signal to noise ratio, i.e., having the smaller quantization/coding distortions.

The decoding scheme in accordance with the present invention is, as stated before, illustrated in Fig. 11B. For each of the three possible output signal kinds, a specific decoding/re-quantizing stage 431, 536 or 537 exists. While stage 431 outputs a frequency-spectrum, which may also be called "time-spectrum" (frequency spectrum of the time domain signal), and which is converted into the time-domain using the frequency/time converter 440, stage 536 outputs an LPC-domain signal, and item 537 receives an frequency-spectrum of the LPC-domain signal, which may also be called an "LPC-spectrum". In order to make sure that the input signals into switch 532 are both in the LPC-domain, a frequency/time converter 537 is provided in the LPC domain. The output data of the switch 532 is transformed back into the time-domain using an LPC synthesis stage 540, which is controlled via encoder-side generated and transmitted LPC information. Then, subsequent to block 540, both branches have time-domain information which is switched in accordance with a switch control signal in order to finally obtain an audio signal such as a mono signal, a stereo signal or a multi-channel signal, which depends on the signal input into the encoding scheme of Fig. 11A.

Fig. 11A therefore, illustrates a preferred encoding scheme in accordance with the invention. A common preprocessing scheme connected to the switch 200 input may comprise a surround/joint stereo block 101 which generates, as an output, joint stereo parameters and a mono output signal, which is generated by downmixing the input signal which is a signal having two or more channels. Generally, the signal at the output of block 101 can also be a signal having more channels, but due to the downmixing functionality of block 101, the number of channels at the output of block 101 will be smaller than the number of channels input into block 101.

The common preprocessing scheme may comprise alternatively to the block 101 or in addition to the block 101 a bandwidth extension stage 102. In the Fig. 11A embodiment, the output of block 101 is input into the bandwidth extension block 102 which, in the encoder of Fig. 11A, outputs a band-limited signal such as the low band signal or the low pass signal at its output. Preferably, this signal is downsampled (e.g. by a factor of two) as well. Furthermore, for the high band of the signal input into block 102, bandwidth extension parameters such as spectral envelope parameters, inverse filtering parameters, noise floor parameters etc. as known from HE-AAC profile of MPEG-4 are generated and forwarded to a bitstream multiplexer 800.

Preferably, the decision stage 300 receives the signal input into block 101 or input into block 102 in order to decide between, for example, a music mode or a speech mode. In the music mode, the upper encoding branch 400 is selected, while, in the speech mode, the lower encoding branch 500 is selected. Preferably, the decision stage additionally controls the joint stereo block 101 and/or the bandwidth extension block 102 to adapt the functionality of these blocks to the specific signal. Thus, when the decision stage determines that a certain time portion of the input signal is of the first mode such as the music mode, then specific features of block 101 and/or block 102 can be controlled by the decision stage 300. Alternatively, when the decision stage 300 determines that the signal is in a speech mode or, generally, in a second LPC-domain mode, then specific features of blocks 101 and 102 can be controlled in accordance with the decision stage output.

Preferably, the spectral conversion of the coding branch 400 is done using an MDCT operation which, even more preferably, is the time-warped MDCT operation, where the strength or, generally, the warping strength can be controlled between zero and a high warping strength. In a zero warping strength, the MDCT operation in block 411 is a straight-forward MDCT operation known in the art. The time warping strength together with time warping side information can be transmitted/input into the bitstream multiplexer 800 as side information.

In the LPC encoding branch, the LPC-domain encoder may include an ACELP core 526 calculating a pitch gain, a pitch lag and/or codebook information such as a codebook index and gain. The TCX mode as known from 3GPP TS 26.290 incurs a processing of a perceptually weighted signal in the transform domain. A Fourier transformed weighted signal is quantized using a split multi-rate lattice quantization (algebraic VQ) with noise factor quantization. A transform is calculated in 1024, 512, or 256 sample windows. The excitation signal is recovered by inverse filtering the quantized weighted signal through an inverse weighting filter.

In the first coding branch 400, a spectral converter preferably comprises a specifically adapted MDCT operation having certain window functions followed by a quantization/entropy encoding stage which may consist of a single vector quantization stage, but preferably is a combined scalar quantizer/entropy coder similar to the quantizer/coder in the frequency domain coding branch, i.e., in item 421 of Fig. 11A.

In the second coding branch, there is the LPC block 510 followed by a switch 521, again followed by an ACELP block 526 or an TCX block 527. ACELP is described in 3GPP TS 26.190 and TCX is described in 3GPP TS 26.290. Generally, the ACELP block 526 receives an LPC excitation signal. The TCX block 527 receives a weighted signal.

In TCX, the transform is applied to the weighted signal computed by filtering the input signal through an LPC-based weighting filter. The weighting filter used in preferred embodiments of the invention is given by $(1-A(z/\gamma))/(1-\mu z^{-})$. Thus, the weighted signal is an LPC domain signal and its transform is an LPC-spectral domain. The signal processed by ACELP block 526 is the excitation signal and is different from the signal processed by the block 527, but both signals are in the LPC domain. The excitation signal is obtained by filtering the input signal through the analysis filter $(1-A(z/\gamma))$.

At the decoder side illustrated in Fig. 11B, after the inverse spectral transform in block 537, the inverse of the weighting filter is applied, that is $(1-\mu z^{-1})/(1-A(z/\gamma))$. Optionally, the signal can be filtered additionally through $(1-A(z))$ to go to the LPC excitation domain. Thus, a signal from the TCX$^{-1}$ block 537 can be converted from the weighted domain to the excitation domain by a filter-

ing through $\dfrac{(1-\mu z^{-1})}{(1-A(z/\gamma))}(1-A(z))$ and then be

used in the block 536. This typical filtering is done in AMR-WB+ at the end of the inverse TCX (537) for feeding the adaptive codebook of ACELP in case this last coding is selected for the next frame.

Although item 510 in Fig. 11A illustrates a single block, block 510 can output different signals as long as these signals are in the LPC domain. The actual mode of block 510 such as the excitation signal mode or the weighted signal mode can depend on the actual switch state. Alternatively, the block 510 can have two parallel processing devices. Hence, the LPC domain at the output of 510 can represent either the LPC excitation signal or the LPC weighted signal or any other LPC domain signal.

In the second encoding branch (ACELP/TCX) of Fig. 11a or 11b, the signal is preferably pre-emphasized through a filter $1-0.68z^{-1}$ before encoding. At the ACELP/TCX decoder in Fig. 11B the synthesized signal is deemphasized with the filter $1/(1-0.68z^{-1})$. The preemphasis can be part of the LPC block 510 where the signal is preemphasized before LPC analysis and quantization. Similarly, deemphasis can be part of the LPC synthesis block LPC$^{-1}$ 540.

In a preferred embodiment, the first switch 200 (see Fig. 11A) is controlled through an open-loop decision and the second switch is controlled through a closed-loop decision.

Exemplarily, there can be the situation that in the first processing branch, the first LPC domain represents the LPC excitation, and in the second processing branch, the second LPC domain represents the LPC weighted signal. That is, the first LPC domain signal is obtained by filtering through $(1-A(z))$ to convert to the LPC residual domain, while the second LPC domain signal is obtained by filtering through the filter $(1-A(z/\gamma))/(1-\mu z^{-1})$ to convert to the LPC weighted domain. In a preferred mode, $\mu$ is equal to 0,68.

Fig. 11B illustrates a decoding scheme corresponding to the encoding scheme of Fig. 11A. The bitstream generated by bitstream multiplexer 800 of Fig. 11a is input into a bitstream demultiplexer 900. Depending on an information derived for example from the bitstream via a mode detection block 601, a decoder-side switch 600 is controlled to either forward signals from the upper branch or signals from the lower branch to the bandwidth extension block 701. The bandwidth extension block 701 receives, from the bitstream demultiplexer 900, side information and, based on this side information and the output of the mode decision 601, reconstructs the high band based on the low band output by switch 600.

The full band signal generated by block 701 is input into the joint stereo/surround processing stage 702, which reconstructs two stereo channels or several multichannels. Generally, block 702 will output more channels than were input into this block. Depending on the application, the input into block 702 may even include two channels such as in a stereo mode and may even include more channels as long as the output by this block has more channels than the input into this block.

The switch 200 has been shown to switch between both branches so that only one branch receives a signal to process and the other branch does not receive a signal to process. In an alternative embodiment, however, the switch may also be arranged subsequent to for example the frequency-domain encoder 421 and the LPC domain encoder 510, 521, 526, 527, which means that both branches 400, 500 process the same signal in parallel. In order to not double the bitrate, however, only the signal output by one of those encoding branches 400 or 500 is selected to be written into the output bitstream. The decision stage will then operate so that the signal written into the bitstream minimizes a certain cost function, where the cost function can be the generated bitrate or the generated perceptual distortion or a combined rate/distortion cost function. Therefore, either in this mode or in the mode illustrated in the Figures, the decision stage can also operate in a closed loop mode in order to make sure that, finally, only the encoding branch output is written into the bitstream which has for a given perceptual distortion the lowest bitrate or, for a given bitrate, has the lowest perceptual distortion.

In the implementation having two switches, i.e., the first switch 200 and the second switch 521, it is preferred that the time resolution for the first switch is lower than the time resolution for the second switch. Stated differently, the blocks of the input signal into the first switch, which can be switched via a switch operation are larger than the blocks switched by the second switch operating in the LPC-domain. Exemplarily, the frequency domain/LPC-domain switch 200 may switch blocks of a length of 1024 samples, and the second switch 521 can switch blocks having 256 or 512 samples each.

Generally, the audio encoding algorithm used in the first encoding branch 400 reflects and models the situation in an audio sink. The sink of an audio information is normally the human ear. The human ear can be modeled as a frequency analyzer. Therefore, the first encoding branch outputs encoded spectral information. Preferably, the first encoding branch furthermore includes a psychoacoustic model for additionally applying a psychoacoustic masking threshold. This psychoacoustic masking threshold is used when quantizing audio spectral values where, preferably, the quantization is performed such that a quantization noise is introduced by quantizing the spectral audio values, which are hidden below the psychoacoustic masking threshold.

The second encoding branch represents an information source model, which reflects the generation of audio sound. Therefore, information source models may include a speech model which is reflected by an LPC analysis stage, i.e., by transforming a time domain signal into an LPC domain and by subsequently processing the LPC residual signal, i.e., the excitation signal. Alternative sound source models, however, are sound source models for representing a certain instrument or any other sound generators such as a specific sound source existing in real world. A selection between different sound source models can be performed when several sound source models are available, for example based on an SNR calculation, i.e., based on a calculation, which of the source models is the best one suitable for encoding a certain time portion and/or frequency portion of an audio signal. Preferably, however, the switch between encoding branches is performed in the time domain, i.e., that a certain time portion is encoded using one model and a certain different time portion of the intermediate signal is encoded using the other encoding branch.

Information source models are represented by certain parameters. Regarding the speech model, the parameters are LPC parameters and coded excitation parameters, when a modern speech coder such as AMR-WB+ is considered. The AMR-WB+ comprises an ACELP encoder and a TCX encoder. In this case, the coded excitation parameters can be global gain, noise floor, and variable length codes.

The audio input signal in Fig. 11A is present in a first domain which can, for example, be the time domain but which can also be any other domain such as a frequency domain, an LPC domain, an LPC spectral domain or any other domain. Generally, the conversion from one domain to the other domain is performed by a conversion algorithm such as any of the well-known time/frequency conversion algorithms or frequency/time conversion algorithms.

An alternative transform from the time domain, for example in the LPC domain is the result of LPC filtering a time domain signal which results in an LPC residual signal or excitation signal. Any other filtering operations producing a filtered signal which has an impact on a substantial number of signal samples before the transform can be used as a transform algorithm as the case may be. Therefore, weighting an audio signal using an LPC based weighting filter is a further transform, which generates a signal in the LPC domain. In a time/frequency transform, the modification of a single spectral value will have an impact on all time domain values before the transform. Analogously, a modification of any time domain sample will have an impact on each frequency domain sample. Similarly, a modification of a sample of the excitation signal in an LPC domain situation will have, due to the length of the LPC filter, an impact on a substantial number of samples before the LPC filtering. Similarly, a modification of a sample before an LPC transformation will have an impact on many samples obtained by this LPC transformation due to the inherent memory effect of the LPC filter.

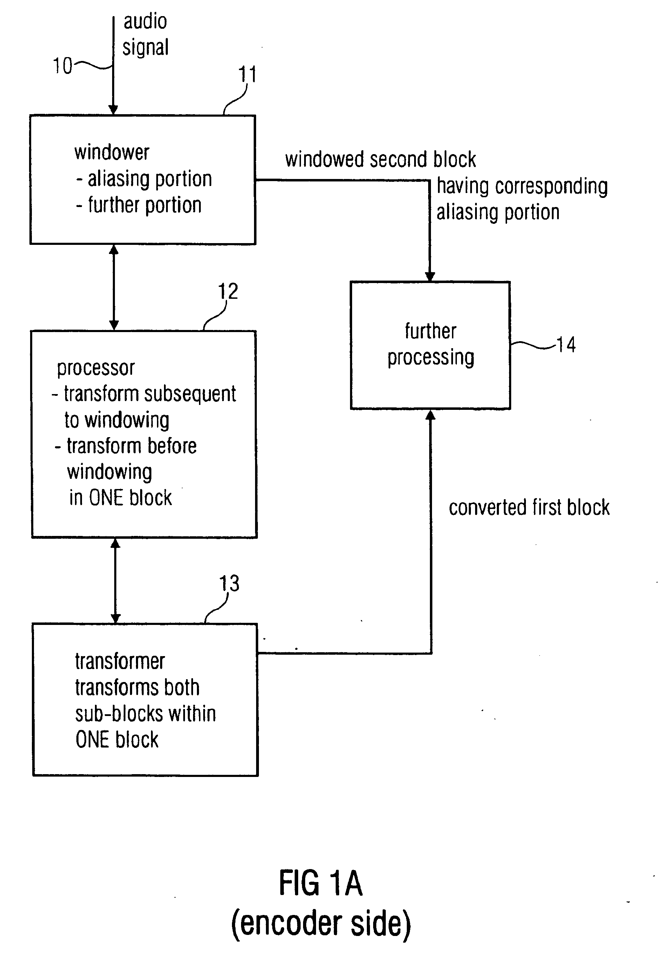

Fig. 1A illustrates a preferred embodiment for an apparatus for encoding an audio signal 10. The audio signal is preferably introduced into a coding apparatus having a first encoding branch such as 400 in Fig. 11A for encoding the audio signal in a third domain which can, for example, be the straightforward frequency domain. The encoder furthermore can comprise a second encoding branch for encoding the audio signal based on a forth domain which can be, for example, the LPC frequency domain as obtained by the TCX block 527 in Fig. 11A.

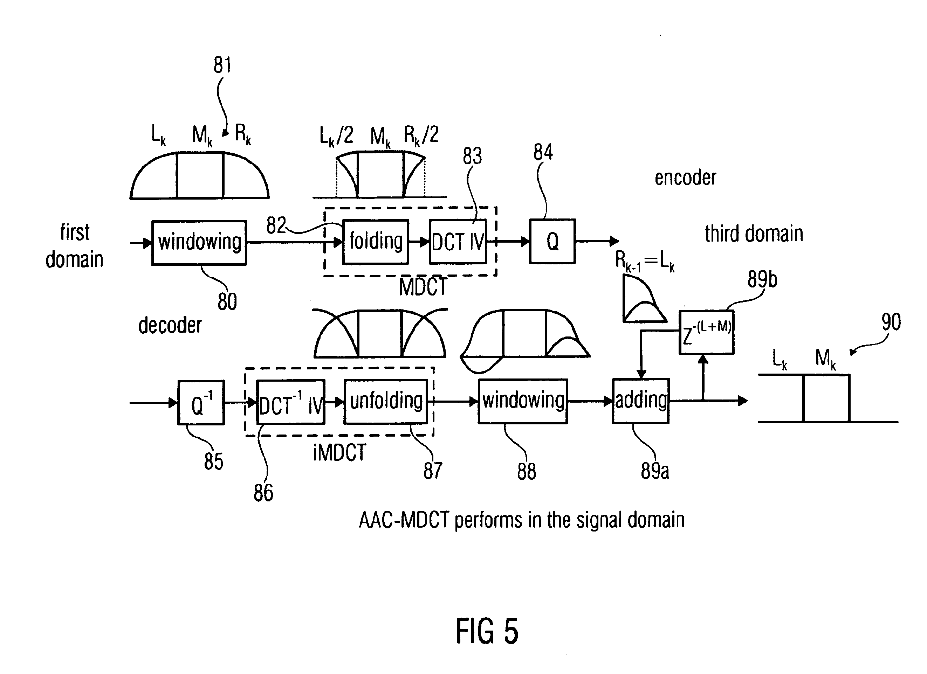

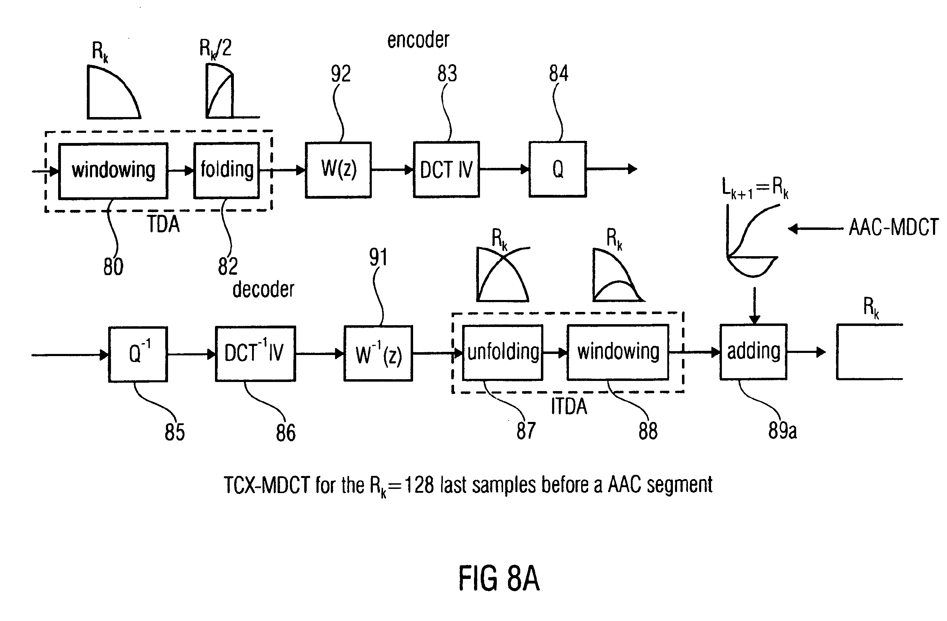

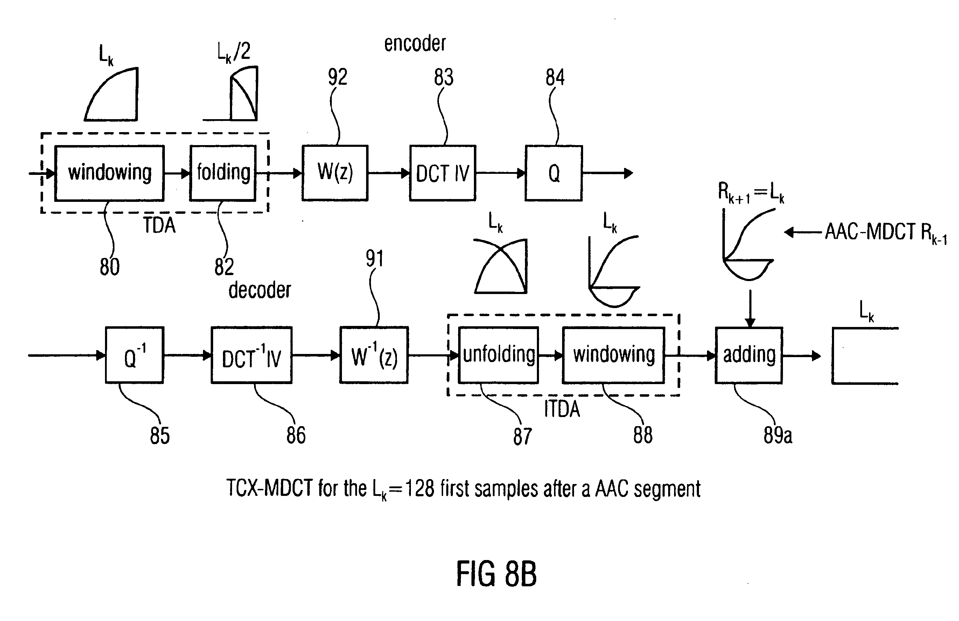

Preferably, the inventive apparatus comprises a windower 11 for windowing the first block of the audio signal in the first domain using a first analysis window having an analysis window shape, the analysis window having an aliasing portion such as $L_k$ or $R_k$ as discussed in the context of Fig. 8A and Fig. 8B or other figures, and having a non-aliasing portion such as $M_k$ illustrated in Fig. 5 or other figures.

The apparatus furthermore comprises a processor 12 for processing a first sub-block of the audio signal associated with the aliasing portion of the analysis window by transforming the sub-block from the first domain such as the signal domain or straightforward time domain into a second domain such as the LPC domain subsequent to windowing the first sub-block to obtain a processed first sub-block, and for processing a second sub-block of the audio signal associated with the further portion of the analysis window by transforming the second sub-block from the first domain such as the straightforward time domain into the second domain such as the LPC domain before windowing the second sub-block to obtain a processed second sub-block. The inventive apparatus furthermore comprises a transformer 13 for converting the processed first sub-block and the processed second sub-block from the second domain into the fourth domain such as the LPC frequency domain using the same block transform rule to obtain a converted first block. This converted first block can, then, be further processed in a further processing stage 14 to perform a data compression.

Preferably, the further processing also receives, as an input, a second block of the audio signal in the first domain overlapping the first block, wherein the second block of the audio signal in the first domain such as the time domain is processed in the third domain, i.e., the straightforward frequency domain using a second analysis window. This second analysis window has an aliasing portion which corresponds to an aliasing portion of the first analysis window. The aliasing portion of the first analysis window and the aliasing portion of the second analysis window preferably relate to the same audio samples of the original audio signal before windowing, and these portions are subjected to a time domain aliasing cancellation, i.e., an overlap-add procedure on the decoder side.

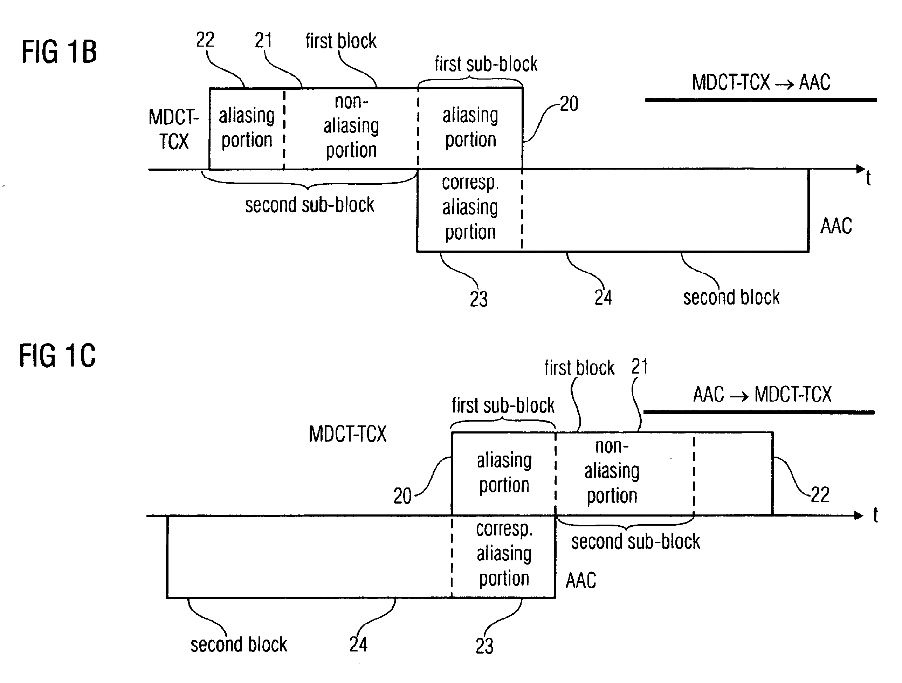

Fig. 1B illustrates the situation occurring, when transition from a block encoded in the fourth domain, for example the LPC frequency domain to a third domain such as the frequency domain takes place. In an embodiment, the fourth domain is the MDCT-TCX domain, and the third domain is the AAC domain. A window applied to the audio signal encoded in the MDCT-TCX domain has an aliasing portion 20 and a non-aliasing portion 21. The same block, which is named "first block" in Fig. 1B may or may not have a further aliasing portion 22. The same is true for the non-aliasing portion. It may or may not be present.

The second block of the audio signal coded in the other domain such as the AAC domain comprises a corresponding aliasing portion 23, and this second block may include further portions such as a non-aliasing portion or an aliasing portion as the case may be, which is indicated at 24 in Fig. 1B. Therefore, Fig. 1B illustrates an overlapping processing of the audio signal so that the audio samples in the aliasing portion 20 of the first block before windowing are identical to the audio samples in the corresponding aliasing portion 23 of the second block before windowing. Hence, the audio samples in the first block are obtained by applying an analysis window to the audio signal which is a stream of audio samples, and the second block is obtained by applying a second analysis window to a number of audio samples which include the samples in the corresponding aliasing portion 23 and the samples in the further portion 24 of the second block. Therefore, the audio samples in the aliasing portion 20 are the first block of the audio signal associated with the aliasing portion 20, and the audio samples in the further portion 21 of the audio signal correspond to the second sub-block of the audio signal associated with the further portion 21.

Fig. 1C illustrates a similar situation as in Fig. 1B, but as a transition from AAC, i.e., the third domain into the MDCT-TCX domain, i.e., the fourth domain.

The difference between Fig. 1B and Fig. 1C is, in general, that the aliasing portion 20 in Fig. 1B includes audio samples occurring in time subsequent to audio samples in the further portion 21, while, in Fig. 1C, the audio samples in the aliasing portion 20 occur, in time, before the audio samples in the further portion 21.

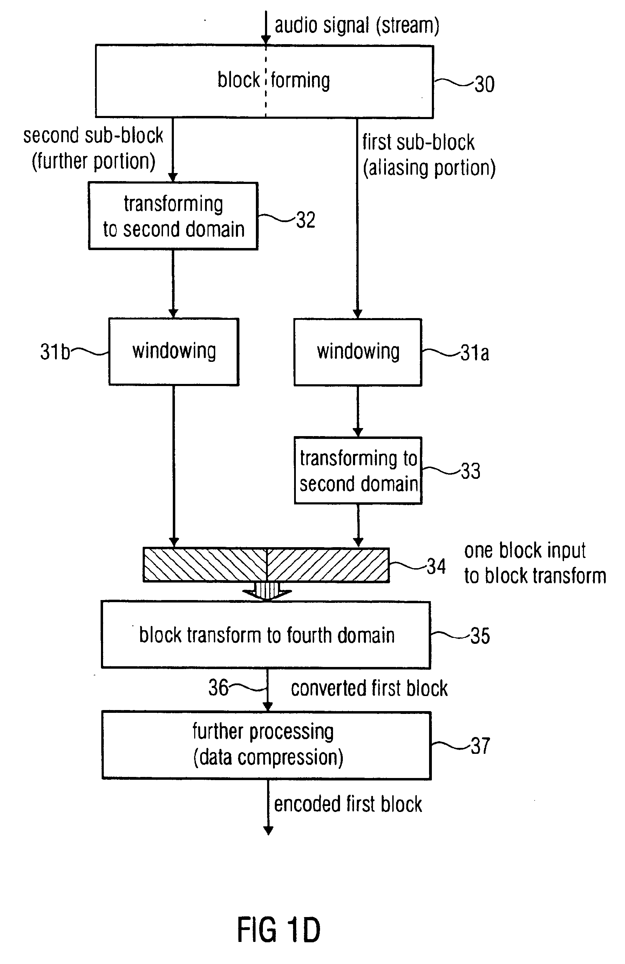

Fig. 1D illustrates a detailed representation of the steps performed with the audio samples in the first sub-block and the second sub-block of one and same windowed block of audio samples. Generally, an window has an increasing portion and a decreasing portion, and depending on the window shape, there can be a relatively constant middle portion or not.

In a first step 30, a block forming operation is performed, in which a certain number of audio samples from a stream of audio samples is taken. Specifically, the block forming operation 30 will define, which audio samples belong to the first block and which audio samples belong to the second block of Fig. 1B and Fig. 1C.

The audio samples in the aliasing portion 20 are windowed in a step 31a. Importantly, however, the audio samples in the non-aliasing portion, i.e., in the second sub-block are transformed into the second domain, i.e., the LPC domain in the preferred embodiment in step 32. Then, subsequent to transforming the audio samples in the second sub-block, the windowing operation 31b is performed. The audio samples claimed by the windowing operation 31b form the samples which are input into a block transform operation to the fourth domain illustrated in Fig. 1D as item 35.

The windowing operation in block 31a, 31b may or may not include a folding operation as discussed in connection with Fig. 8A, 8B, 9A, 10A. Preferably, the windowing operation 31a, 31b additionally comprises a folding operation.

However, the aliasing portion is transformed into the second domain such as the LPC domain in block 33. Thus, the block of samples to be transformed into the fourth domain which is indicated at 34 is completed, and block 34 constitutes one block of data input into one block transform operation, such as a time/frequency operation. Since the second domain is, in the preferred embodiment the LPC domain, the output of the block transform operation as in step 35 will be in the fourth domain, i.e., the LPC frequency domain. This block generated by block transform 35 will be the converted first block 36, which is then first processed in step 37, in order to apply any kind of data compression which comprises, for example, the data compression operations applied to TCX data in the AMR-WB+ coder. Naturally, all other data compression operations can be performed as well in block 37. Therefore, block 37 corresponds to item 14 in Fig. 1A, and block 35 in Fig. 1D corresponds to item 13 in Fig. 1A, and the windowing operations correspond to 31b and 31a in Fig. 1D correspond to item 11 in Fig. 1A, and scheduling of the order between transforming and windowing which is different for the further portion and the aliasing portion is performed by the processor 12 in Fig. 1A.

Fig. 1D illustrates the case, in which the further portion consists of the non-aliasing sub-portion 21 and an aliasing sub-portion 22 of Fig. 1B or 1C. Alternatively, the further portion can only include an aliasing portion without a non-aliasing portion. In this case, 21 in Fig. 1B and 1C would not be there and 22 would extend from the border of the block to the border of the aliasing portion 20. In any case, the further portion/further sub-block is processed in the same way (irrespective of being fully aliasing-free or fully aliasing or having an aliasing sub-portion and a non-aliasing sub-portion), but differently from the aliasing sub-block.

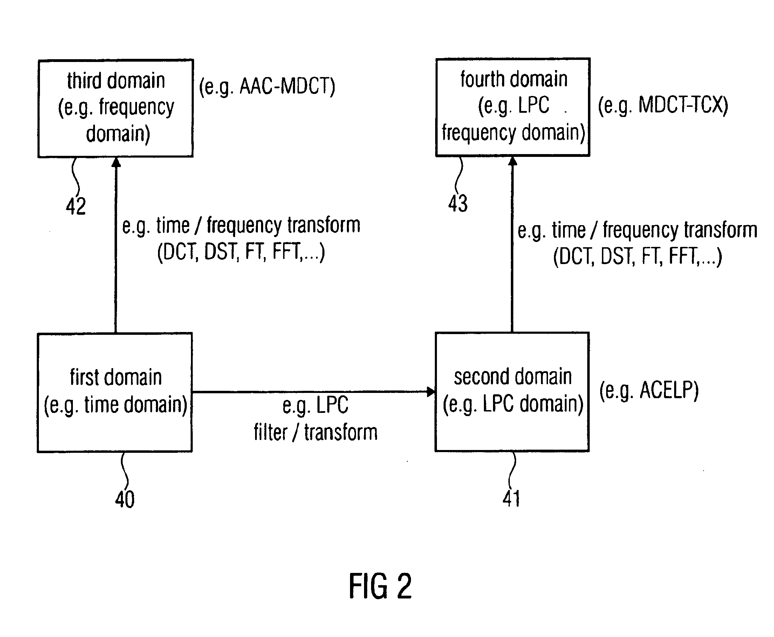

Fig. 2 illustrates an overview over different domains which occur in preferred embodiments of the present invention.

Normally, the audio signal will be in the first domain 40 which can, for example, be the time domain. However, the invention actually applies to all situations, which occur when an audio signal is to be encoded in two different domains, and when the switch from one domain to the other domain has to be performed in a bitrate optimum way, i.e., using critically sampling.

The second domain will be, in a preferred embodiment, an LPC domain 41. A transform from the first domain to the second domain will be done via an LPC filter/transform as indicated in Fig. 2.

The third domain is, in a preferred embodiment, the straightforward frequency domain 42, which is obtained by any of the well-known time/frequency transforms such as a DCT (discrete cosine transform), a DST (discrete sine transform), a Fourier transform or a fast Fourier transform or any other time/frequency transform.

Correspondingly, a conversion from the second domain into a fourth domain 43, such as an LPC frequency domain or, generally stated, the frequency domain with respect to the second domain 41 can also be obtained by any of the well-known time/frequency transform algorithms, such as DCT, DST, FT, FFT.

Then Fig. 2 is compared to Fig. 11A or 11B, the output of block 421 will have a signal in the third domain. Furthermore, the output of block 526 will have a signal in the second domain, and the output of block 527 will comprise a signal in the fourth domain. The other signal input into switch 200 or, generally, input into the decision stage 300 or the surround/joint stereo stage 101 will be in the first domain such as the time domain.

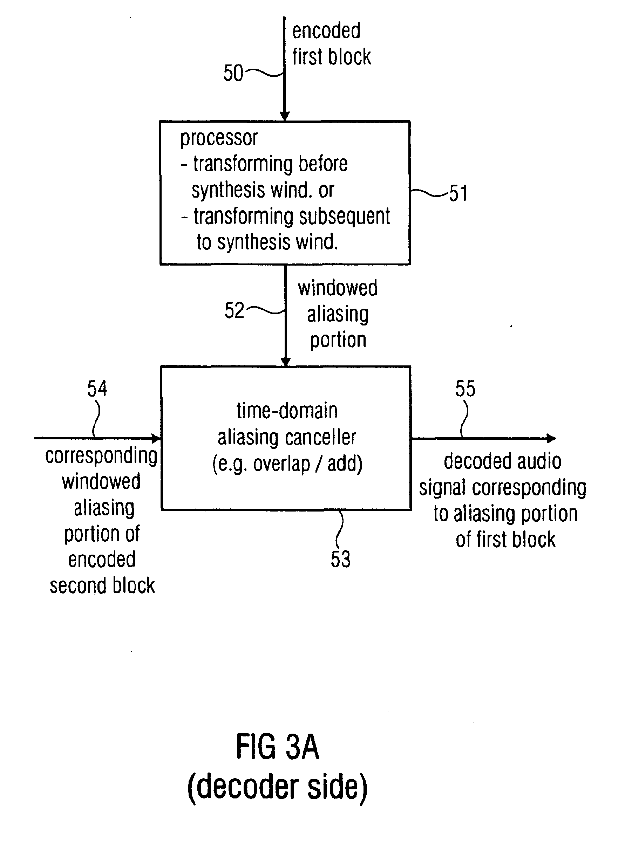

Fig. 3A illustrates a preferred embodiment of an inventive apparatus for decoding an encoded audio signal having an encoded first block 50 of audio data, where the encoded block has an aliasing portion and a further portion. The inventive decoder furthermore comprises a processor 51 for processing the aliasing portion by transforming the aliasing portion into a target domain for performing a synthesis windowing to obtain a windowed aliasing portion 52, and for performing a synthesis windowing of the further portion before performing a transform of the windowed further portion into the target domain.

Therefore, on the decoder side, portions of a block belonging to the same window are processed differently. A similar processing has been applied on the encoder side to allow a critically sampled switch over between different domains.

The inventive decoder furthermore comprises a time domain aliasing canceller 53 for combining the windowed aliasing portion of the first block, i.e., input 52, and a windowed aliasing portion of an encoded second block of audio data subsequent to a transform of the aliasing portion of the encoded second block into the target domain, in order to obtain a decoded audio signal 55, which corresponds to the aliasing portion of the first block. The windowed aliasing portion of the encoded second block is input via 54 into the time domain aliasing canceller 53.

Preferably, a time domain aliasing canceller 53 is implemented as an overlap/add device, which, for example applies a 50% overlap. This means that the result of a synthesis window of one block is overlapped with the result of a synthesis window processing of an adjacent encoded block of audio data, where this overlap preferably comprises 50% of the block. This means that the second portion of synthesis windowed audio data of an earlier block is added in a sample-wise manner to the first portion of a later second block of encoded audio data, so that, in the end, the decoded audio samples are the sum of corresponding windowed samples of two adjacent blocks. In other embodiments, the overlapping range can be more or less than 50%. This combining feature of the time domain aliasing canceller provides a continuous cross-fade from one block to the next, which completely removes any blocking artifacts occurring in any block-based transform coding scheme. Due to the fact that aliasing portions of different domains can be combined by the present invention, a critically sampled switching operation from a block of one domain to a block of the other domain is obtained.

Compared to a switch encoder without any cross-fading, in which a hard switch from one block to the other block is performed, the audio quality is improved by the inventive procedure, since the hard switch would inevitably result in blocking artifacts such as audible cracks or any other unwanted noise at the block border.

Compared to the non-critically sampled cross-fade, which indeed, would remove such an unwanted sharp noise at the block border, however, the present invention does not result in any data rate increase due to the switch. When, in the prior art, the same audio samples would be encoded in the first block via the first coding branch and would be encoded in the second block via the second coding branch, a sample amount has been encoded in both coding branches would consume bit rate, when it would be processed without an aliasing introduction. In accordance with the present invention, however, an aliasing is introduced at the block borders. This aliasing-introduction which is obtained by a sample reduction, however, results in a possibility to apply a cross-fading operation by the time domain aliasing canceller 53 without the penalty of an increased bit rate or a non-critically sampled switch-over.

In the most preferred embodiment, a truly critically sampled switchover is performed. However, there can also be, in certain situations, less efficient embodiments, in which only a certain amount of aliasing is introduced and a certain amount of bit rate overhead is allowed. Due to the fact that aliasing portions are used and combined, however, all these less efficient embodiments are, nevertheless, always better than a completely aliasing free transition with cross-fade or are with respect to quality, better than a hard switch from one encoding branch to the other encoding branch.

In this context, it is to be noted that the non-aliasing portion in TCX still produces critically sampled coded samples. Adding a non-aliasing portion in TCX does not compromise the critical sampling, but compromises the quality of the transition (lower handover) and the quality of the spectral representation (lower energy compaction).

In view of this, it is preferred to have the non-aliasing portion in TCX as small as possible or even close to zero so that the further portion is fully aliasing and does not have an aliasing-free sub-portion.

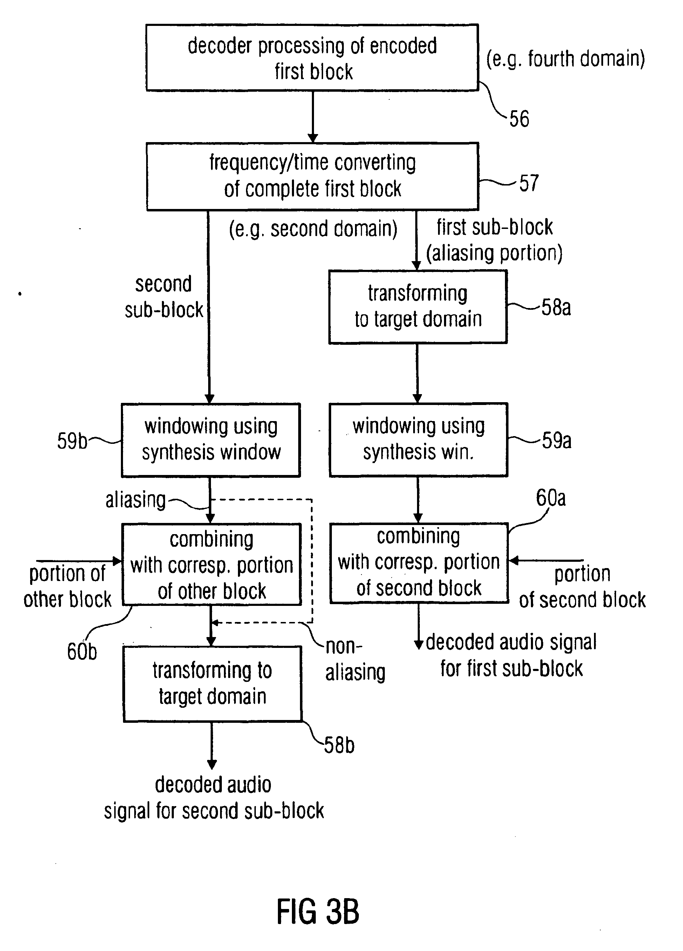

Subsequently, Fig. 3B will be discussed in order to illustrate a preferred embodiment of the procedure in Fig. 3A.

In a step 56, the decoder processing of the encoded first block which is, for example, in the fourth domain, is performed. This decoder processing may be an entropy-decoding such as Huffman decoding or an arithmetic decoding corresponding to the further processing operations in block 14 of Fig. 1A on the encoder side. In step 57, a frequency/time conversion of the complete first block is performed as indicated at step 57. In accordance with Fig. 2, this procedure in step 57 results in a complete first block in the second domain. Now, in accordance with the present invention, the portions of the first block are processed differently. Specifically, the aliasing portion, i.e., the first sub-block of the output of step 57 will be transformed to the target domain before a windowing operation using a synthesis window is performed. This is indicated by the order of the transforming step 58a and the windowing step 59a. The second sub-block, i.e., the aliasing-free sub-block is windowed using a synthesis window as indicated at 59b, as it is, i.e., without the transforming operation in item 58a in Fig. 3B. The windowing operation in block 59a or 59b may or may not comprise a folding (unfolding) operation. Preferably, however, the windowing operation comprises a folding (unfolding operation).

Depending on whether the second sub-block corresponding to the further portion is indeed an aliasing sub-block or a non-aliasing sub-block, the transforming operation into the target domain as indicated at 59b is performed without any TDAC operation/combining operation in the case of the second sub-block being a non-aliasing sub-block. When, however, the second sub-block is an aliasing sub-block, a TDAC operation, i.e., a combining operation 60b is performed with a corresponding portion of another block, before the transforming operation into the target domain in step 59b is obtained to calculate the decoded audio signal for the second block.

In the other branch, i.e., for the aliasing portion corresponding to the first sub-block, the result of the windowing operation in step 59a is input into a combining stage 60a. This combining stage 60a also receives, as an input, the aliasing portion of the second block, i.e., the block which has been encoded in the other domain, such as the AAC domain in the example of Fig. 2. Then, the output of block 60a constitutes the decoded audio signal for the first sub-block.

When, Fig. 3A and Fig. 3B are compared, it becomes clear that the combining operation 60a corresponds to the processing performed in the block 53 of Fig. 3A. Furthermore, the transforming operation and the windowing operation performed by the processor 51 corresponds to items 58a, 58b with respect to the transforming operation and 59a and 59b with respect to the windowing operation, where the processor 51 in Fig. 3A furthermore insures that the correct order for the aliasing portion and the other portion, i.e., the second sub-block, is maintained.

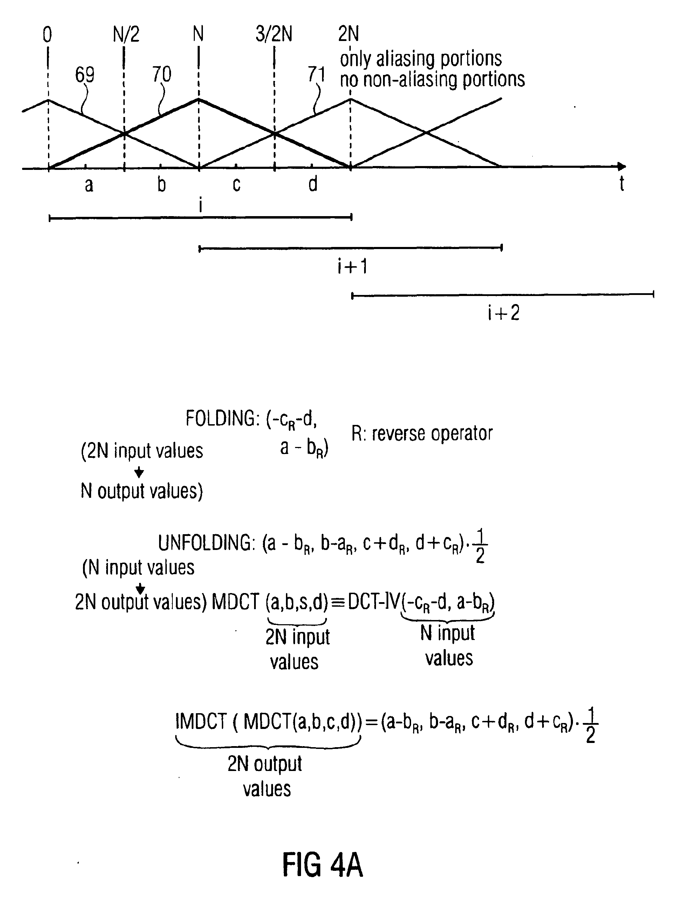

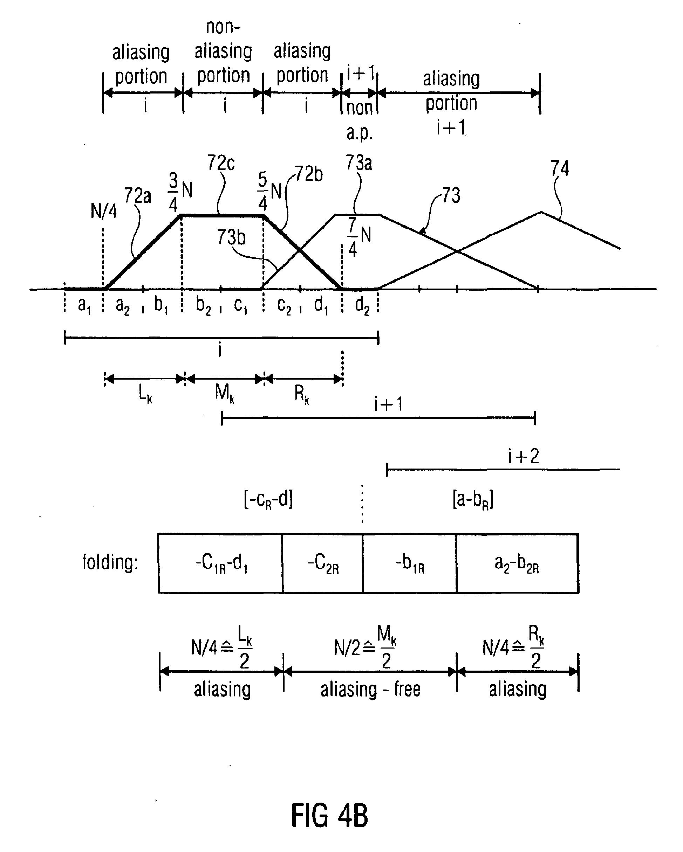

In the preferred embodiment, the modified discrete cosine transform (MDCT) is applied in order to obtain the critically sampling switchover from an encoding operation in one domain to an encoding operation in a different other domain. However, all other transforms can be applied as well. Since, however, the MDCT is the preferred embodiment, the MDCT will be discussed in more detail with respect to Fig. 4A and Fig. 4B.

Fig.4A illustrates a window 70, which has an increasing portion to the left and a decreasing portion to the right, where one can divide this window into four portions: a, b, c, and d. Window 70 has, as can be seen from the figure only aliasing portions in the 50% overlap/add situation illustrated. Specifically, the first portion having samples from zero to N corresponds to the second portions of a preceding window 69, and the second half extending between sample N and sample 2N of window 70 is overlapped with the first portion of window 71, which is in the illustrated embodiment window i+1, while window 70 is window i.

The MDCT operation can be seen as the cascading of the folding operation and a subsequent transform operation and, specifically, a subsequent DCT operation, where the DCT of type-IV (DCT-IV) is applied. Specifically, the folding operation is obtained by calculating the first portion N/2 of the folding block as $-c_R-d$, and calculating the second portion of N/2 samples of the folding output as $a-b_R$, where R is the reverse operator. Thus, the folding operation results in N output values while 2N input values are received.

A corresponding unfolding operation on the decoder-side is illustrated, in equation form, in Fig. 4A as well.

Generally, an MDCT operation on (a,b,c,d) results in exactly the same output values as the DCT-IV of $(-c_R-d, a-b_R)$ as indicated in Fig. 4A.

Correspondingly, and using the unfolding operation, an IMDCT operation results in the output of the unfolding operation applied to the output of a DCT-IV inverse transform.

Therefore, time aliasing is introduced by performing a folding operation on the decoder-side. Then, the result of the folding operation is transformed into the frequency domain using a DCT-IV block transform requiring N input values.

On the decoder-side, N input values are transformed back into the time domain using a DCT-IV$^{-1}$ operation, and the output of this inverse transform operation is thus changed into an unfolding operation to obtain 2N output values which, however, are aliased output values.

In order to remove the aliasing which has been introduced by the folding operation and which is still there subsequent to the unfolding operation, the overlap/add operation by the time domain aliasing canceller 53 of Fig. 3A is required.

Therefore, when the result of the unfolding operation is added with the previous IMDCT result in the overlapping half, the reversed terms cancel in the equation in the bottom of Fig. 4A and one obtains simply, for example, b and d, thus recovering the original data.

In order to obtain a TDAC for the windowed MDCT, a requirement exists, which is known as "Princen-Bradley" condition, which means that the window coefficients raised to 2 for the corresponding samples which are combined in the time domain aliasing canceller as to result in unity (1) for each sample.

While Fig. 4A illustrates the window sequence as, for example, applied in the AAC-MDCT for long windows or short windows, Fig. 4D illustrates a different window function which has, in addition to aliasing portions, a non-aliasing portion as well.

Fig. 4D illustrates an analysis window function 72 having a zero portion $a_1$ and $d_2$, having an aliasing portion 72a, 72b, and having a non-aliasing portion 72c.

The aliasing portion 72b extending over $c_2$, $d_1$ has a corresponding aliasing portion of a subsequent window 73, which is indicated at 73b. Correspondingly, window 73 additionally comprises a non-aliasing portion 73a. Fig. 4B, when compared to Fig. 4A makes clear that, due to the fact that there are zero portions $a_1$, $d_1$, for window 72 or $c_1$ for window 73, both windows receive a non-aliasing portion, and the window function in the aliasing portion is steeper than in Fig. 4A. In view of that, the aliasing portion 72a corresponds to $L_k$, the non-aliasing portion 72c corresponds to portion $M_k$, and the aliasing portion 72b corresponds to $R_k$ in Fig. 4B.

When the folding operation is applied to a block of samples windowed by window 72, a situation is obtained as illustrated in Fig. 4B. The left portion extending over the first N/4 samples has aliasing. The second portion extending over N/2 samples is aliasing-free, since the folding operation is applied on window portions having zero values, and the last N/4 samples are, again, aliasing-affected. Due to the folding operation, the number of output values of the folding operation is equal to N, while the input was 2N, although, in fact, N/2 values in this embodiment were set to zero due to the windowing operation using window 72.

Now, the DCT IV is applied to the result of the folding operation, but, importantly, the aliasing portion 72 which is at the transition from one coding mode to the other coding mode is differently processed than the non-aliasing portion, although both portions belong to the same block of audio samples and, importantly, are input into the same block transform operation performed by the transformer 30 in Fig. 1A.

Fig. 4B furthermore illustrates a window sequence of windows 72, 73, 74, where the window 73 is a transition window from a situation where there does exist non-aliasing portions to a situation, where only exist aliasing portions. This is obtained by asymmetrically shaping the window function. The right portion of window 73 is similar to the right portion of the windows in the window sequence of Fig. 4A, while the left portion has a non-aliasing portion and the corresponding zero portion (at $c_1$). Therefore, Fig. 4B illustrates a transition from MDCT-TCX to AAC, when AAC is to be performed using fully-overlapping windows or, alternatively, a transition from AAC to MDCT-TCX is illustrated, when window 74 windows a TCX data block in a fully-overlapping manner, which is the regular operation for MDCT-TCX on the one hand and MDCT-AAC on the other hand when there is no reason for switching from one mode to the other mode.

Therefore, window 73 can be termed to be a "start window" or a "stop window", which has, in addition, the preferred characteristic that the length of this window is identical to the length of at least one neighboring window so that the general block raster or frame raster is maintained, when a block is set to have the same number as window coefficients, i.e., 2n samples in the Fig. 4D or Fig. 4A example.

Subsequently, the AAC-MDCT procedure on the encoder-side and on the decoder-side is discussed with respect to Fig. 5.

In a windowing operation 80, a window function is illustrated at 81 is applied. The window function has two aliasing portions $L_k$ and $R_k$, and a non-aliasing portion $M_k$. Therefore, the window function 81 is similar to the window function 72 in Fig. 4B. Applying this window function to a corresponding, plurality of audio samples results in the windowed block of audio samples having an aliasing sub-block corresponding to $R_k/L_k$ and a non-aliasing sub-block corresponding to $M_k$.

The folding operation illustrated by 82 is performed as indicated in Fig. 4B and results in N outputs, which means that the portions $L_k$, $R_k$ are reduced to have a smaller number of samples.

Then, a DCT IV 83 is performed as discussed in connection with the MDCT equation in Fig. 4A. The MDCT output is further processed by any available data compressor such as a quantizer 84 or any other device performing any of the well-known AAC tools.

On the decoder side, an inverse processing 85 is performed. Then, a transform from the third domain into the first domain is performed via the DCT$^{-1}$ IV 86. Then, an unfolding operation 87 is performed as discussed in connection with Fig. 4A. Then, in a block 88, a synthesis windowing operation is performed, and items 89a and 89b together perform a time domain aliasing cancellation. Item 89b is a delay device applying a delay of $M_k+R_k$ samples in order to obtain the overlap as discussed in connection with Fig. 4A, and adder 89a performs a combination of the current portion of the audio samples such as the first portion $L_k$ of a current window output and the last portion $R_{k-1}$ of the previous window. This results, as indicated at 90, in aliasing-free portions $L_k$ and $M_k$. It is to be noted that $M_k$ was aliasing-free from the beginning, but the processing by the devices 89a, 89b has cancelled the aliasing in the aliasing portion $L_k$.

In the preferred embodiment, the AAC-MDCT can also be applied with windows only having aliasing portions as indicated in Fig. 4A, but, for a switch between one coding mode to the other coding mode, it is preferred that an AAC window having an aliasing portion and having a non-aliasing portion is applied.

An embodiment of the present invention is used in a switched audio coding which switches between AAC and AMR-WB+[4].

AAC uses a MDCT as described in Fig. 5. AAC is very well suited for music signal. The switched coding uses AAC when the input signal is detected in a previous processing as music or labeled as music by the user.

The input signal frame $k$ is windowed by a three parts window of sizes $L_k$, $M_k$ and $R_k$. The MDCT introduces time-domain aliasing components before transforming the signal in frequency domain where the quantization is performed. After adding the overlapped previous windowed signal of size $R_{k-1} = L_k$, the $L_k+M_k$ first samples of original signal frame could be recovered if any quantization error was introduced. The time-domain aliasing is cancelled.

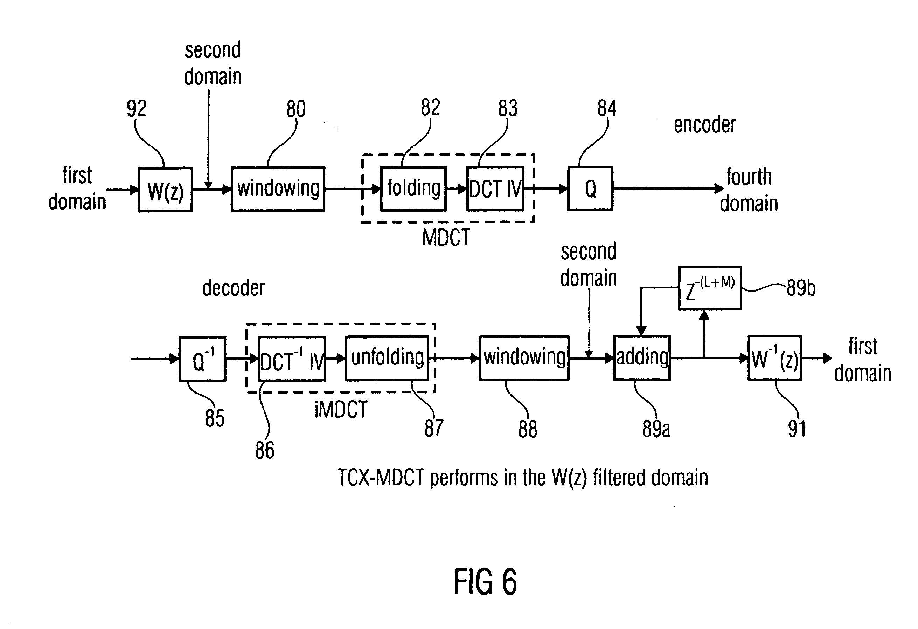

Subsequently, the TCX-MDCT procedure with respect to the present invention is discussed in connection with Fig. 6.

In contrast to the encoder in Fig. 5, a transform into the second domain is performed by item 92. Item 92 is an LPC transformer either generating an LPC residual signal or a weighted signal which can be calculated by weighting an LPC residual signal using a weighting filter as known from TCX processing. Naturally, the TCX signal can also be calculated with a single filter by filtering the time domain signal in order to obtain the TCX signal, which is a signal in the LPC domain or, generally state, in the second domain. Therefore, the first domain/second domain converter 92 provides, at its output site, the signal input into the windowing device 80. Apart from the transformer 92, the procedure in the encoder in Fig. 6 is similar to the procedure in the encoder of Fig. 5. Naturally, one can apply different data compression algorithms in blocks 84 in Fig. 5 and Fig. 6, which are readily apparent, when the AAC coding tools are compared to the TCX coding tools.

On the decoder side, the same steps as discussed in connection with Fig. 5 are performed, but these steps are not performed on an encoded signal in the straightforward frequency domain (third domain), but are performed on a coded signal which is generated in the fourth domain, i.e., the LPC frequency domain.

Therefore, the overlap add procedure by devices 89a, 89b in Fig. 6 is performed in the second domain rather than in the first domain as illustrated in Fig. 5.

AMR-WB+ is based on a speech coding ACELP and a transform-based coding TCX. For each superframe of 1024 samples, AMR-WB+ select with closed-loop decision between 17 different combination of TCX and ACELP, the best one according to closed-decision using the SegSNR objective evaluation. The AMR-WB+ is well-suited for speech and speech over music signals. The original DFT of the TCX was replaced by a MDCT in order to enjoy its great properties. The TCX of AMR-WB+ is then equivalent to the MPTC coding excepting for the quantization which was kept as it is. The modified AMR-WB+ is used by the switched audio coder when the input signal is detected or labeled as speech or speech over music.

The TCX-MDCT performs a MDCT not directly on the signal domain but after filtering the signal by a analysis filter W(z) based on an LPC coefficient. The filter is called weighting analysis filter and permits the TCX in the same time to whiten the signal and to shape the quantization noise by a formant-based curve which is in line with psycho-acoustic theories.

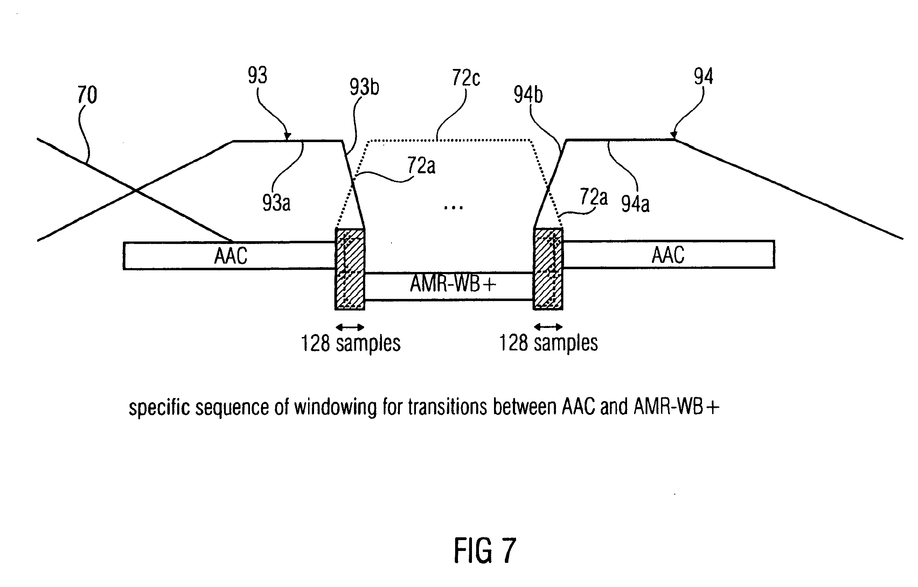

The processing illustrated in Fig. 5 is performed for a straightforward AAC-MDCT mode without any switching to TCX mode or any other mode using the fully overlapping windows in Fig.4A. When, however, a transition is detected, a specific window is applied, which is an AAC start window for a transition to the other coding mode or an AAC stop window for the transition from the other coding mode into the AAC mode as illustrated in Fig. 7. An AAC stop window 93 has an aliasing portion illustrated at 93b and a non-aliasing portion illustrated at 93a, i.e., indicated in the figure as the horizontal part of the window 93. Correspondingly, the AAC stop window 94 is illustrated as having an aliasing portion 94b and a non-aliasing portion 94a. In the AMR-WB+ portion, a window is applied similar to window 72 of Fig. 4B, where this window has an aliasing portion 72a and a non-aliasing portion 72c. Although only a single AMR-WB+ window which can be seen as a start/stop window as illustrated in Fig. 7, there can be a plurality of windows which, preferably, have a 50% overlapping and can, therefore, be similar to the windows in Fig. 4A. Usually TCX in AMR-WB+ does not use any 50% overlap. Only a small overlap is adopted for being able to switch promptly to/from ACELP which uses inherently rectangular window, i.e. 0% of overlap.

However, when the transition takes place, an AMR-WB+ start window is applied illustrated at the left center position in Fig. 7, and when it is decided that the transition from AMR-WB+ to AAC is to be performed, an AMR-WB+ stop window is applied. The start window has an aliasing portion to the left and the stop window has an aliasing portion to the right, where these aliasing portions are indicated as 72a, and where these aliasing portions correspond to the aliasing portions of the neighboring AAC start/stop windows indicated at 93b or 94b.

The specific processing occurs in the two overlapped regions of 128 samples of Fig. 7. For canceling the time-domain aliasing of AAC, the first and the last frames of the AMR-WB+ segment are forced to be TCX and not ACELP. this is done by biasing the SegSNR score in the closed-loop decision. Furthermore the first 128 samples of the TCX-MDCT are processed specifically as illustrated in Figure 8A, where $L_k$=128.

The last 128 samples of AMR-WB+ are processed as illustrated in the Figure 8B, where $R_k$=128.

Fig. 8A illustrates the processing for the aliasing portion $R_k$ to the right of the non-aliasing portion for a transition from TCX to AAC, and Fig. 8B illustrates the specific processing of the aliasing portion $L_k$ to the left of a non-aliasing portion for a transition from AAC to TCX. The processing is similar with respect to Fig. 6, but the weighting operation, i.e., the transform from the first domain to the second domain is positioned differently. Specifically, in Fig. 6, the transform is performed before windowing, while, in Fig. 8B, the transform 92 is performed subsequent to the windowing 80 (and the folding 82), i.e., the time domain aliasing introducing operation indicated by "TDAC".

On the decoder side, again, quite similar processing steps as in Fig. 6 are performed, but, again, the position of the inverse weighting for the aliasing portion is before windowing 88 (and before unfolding 87) and subsequent to the transform from the first domain to the second domain indicated by 86 in Fig. 8A.

Therefore, in accordance with a preferred embodiment of the present invention, the aliasing portion of a transition window for TCX is processed as indicated in Fig. 1A or Fig. 1B, and a non-aliasing portion for the same window is processed in accordance with Fig. 6.

The processing for any AAC-MDCT window remains the same apart from the fact that a start window or a stop window is selected at the transition. In other embodiments, however, the TCX processing can remain the same and the aliasing portion of the AAC-MDCT window is processed differently compared to the non-aliasing portion.

Furthermore, both aliasing portions of both windows, i.e., an AAC window or a TCX window can be processed differently from their non-aliasing portions as the case may be. In the preferred embodiment, however, it is preferred that the AAC processing is done as it is, since it is already in the signal domain subsequent to the overlap-add procedure as is clear from Fig. 5, and that the TCX transition window is processed as illustrated in the context of Fig. 6 for a non-aliasing portion and as illustrated in Fig. 8A or 8B for the aliasing portion.

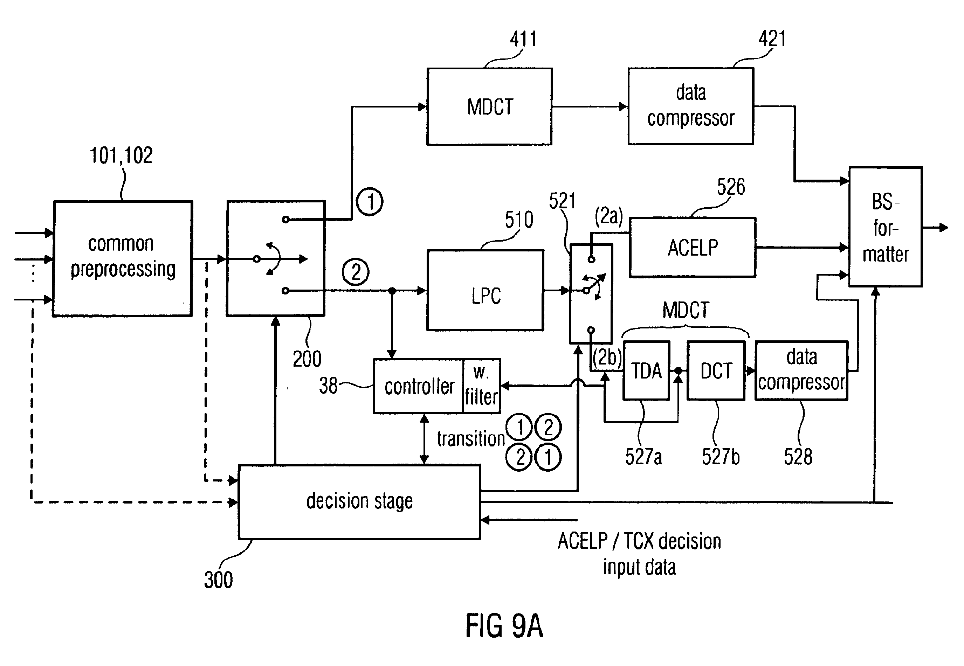

Subsequently, Fig. 9A will be discussed, in which the processor 12 of Fig. 1A has been indicated as a controller 98.

Devices in Fig. 9A having corresponding reference numerals which correspond to items of Fig. 11A have a similar functionality and are not discussed again.

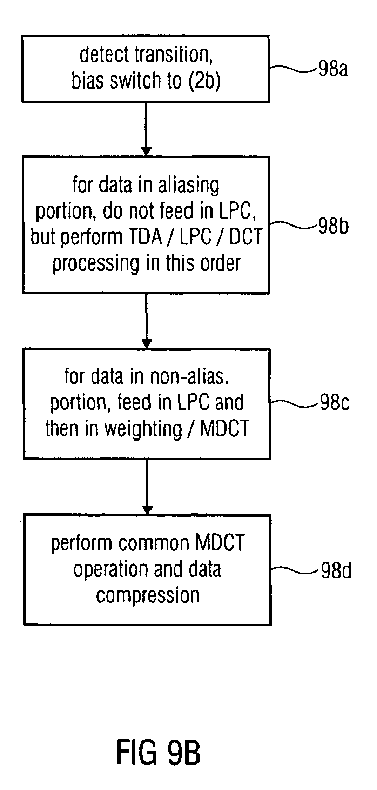

Specifically, the controller 98 illustrated in Fig. 9A operates as indicated in Fig. 9B. In step 98a, a transition is detected, where this transition is indicated by the decision stage 300. Then, the controller 98 is active to bias the switch 521 so that the switch 521 selects alternative (2b) in any case.

Then, step 98b is performed by the controller 98. Specifically, the controller is operative to take the data in the aliasing portion and to not feed the data into the LPC 510 directly, but to feed the data before LPC filter 510 directly, without weighting by an LPC filter, into the TDA block 527a. Then, this data is taken by the controller 98 and weighted and, then, fed into DCT block 527b, i.e., after having been weighted by the weighting filter at the controller 98 output. The weighting filter at the controller 98 uses the LPC coefficients calculated in the LPC block 510 after a signal analysis. The LPC block is able to feed either ACELP or TCX and moreover perform a LPC analysis for obtaining the LPC coefficients.The DCT portion 527b of the MDCT device consists of the TDA device 527a and the DCT device 527b. The weighting filter at the output of the controller 98 has the same characteristic as the filter in the LPC block 510 and a potentially present additional weighting filter such as the perceptual filter in AMR-WB+ TCX processing. Hence, in step 98b, TDA-, LPC-, and DCT processing are performed in this order.

The data in the further portion is fed into the LPC block 510 and, subsequently, in the MDCT block 527a, 527b as indicated by the normal signal path in Fig. 9A. In this case, the TCX weighting filter is not explicitly illustrated in Fig. 9A because it belongs to the LPC block 510.

As stated before, the data in the aliasing portion is, as indicated in Fig. 8A windowed in block 527a, and the windowed data generated within block 527 is LPC filtered at the controller output and the result of the LPC filtering is then applied to the transform portion 527b of the MDCT block 527. The TCX weighting filter for weighting the LPC residual signal generated by LPC device 510 is not illustrated in Fig. 9A. Additionally, device 527a includes the windowing stage 80 and, the folding stage 82 and device 527b includes the DCT IV stage 83 as discussed in connection with Fig. 8A. The DCT IV stage 83/527b then receives the aliasing portion after processing and the further portion after the corresponding processing and performs the common MDCT operation, and a subsequent data compression in block 528 is performed as indicated by step 98d in Fig. 9B. Therefore, in case of an encoder hardwired or software-controlled as discussed in connection with Fig. 9A, the controller 98 performs the data scheduling as indicated in Fig. 9D between the different blocks 510 and 527a, 527b.

On the decoder side, a transition controller 99 is provided in addition to the blocks indicated in Fig. 11B, which have already been discussed.

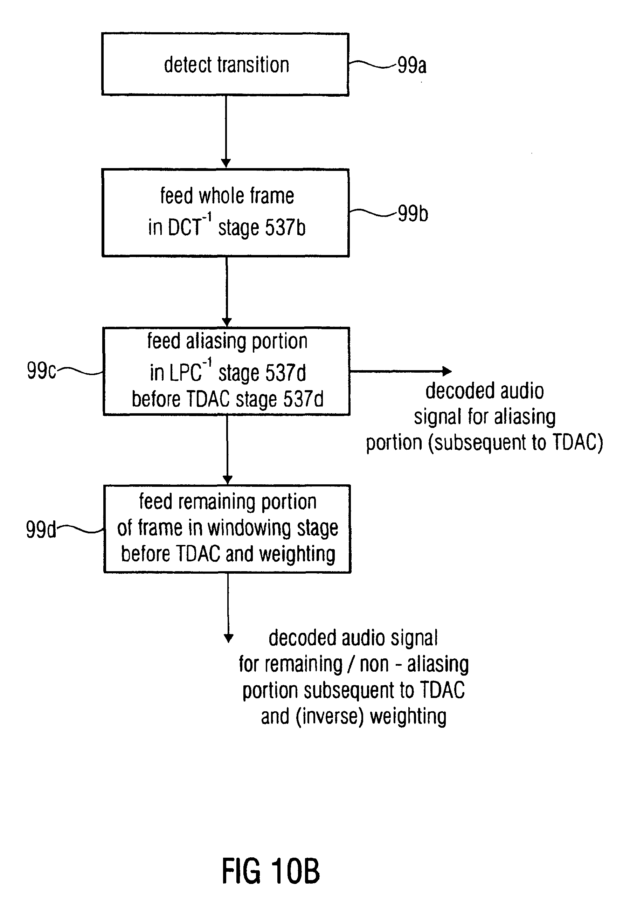

The functionality of the transition controller 99 is discussed in connection with Fig. 10B.

As soon as the transition controller 99 has detected a transition as outlined in step 99a in Fig. 10B, the whole frame is fed into the MDCT$^{-1}$ stage 537b subsequent to a data decompression in data decompressor 537a. This procedure is indicated in step 99b of Fig. 10B. Then, as indicated in step 99c, the aliasing portion is fed directly into the LPC$^{-1}$ stage before performing a TDAC processing. However, the aliasing portion is not subjected to a complete "MDCT" processing, but only, as illustrated in Fig. 8B, subjected to the inverse transform from the fourth domain to the second domain.

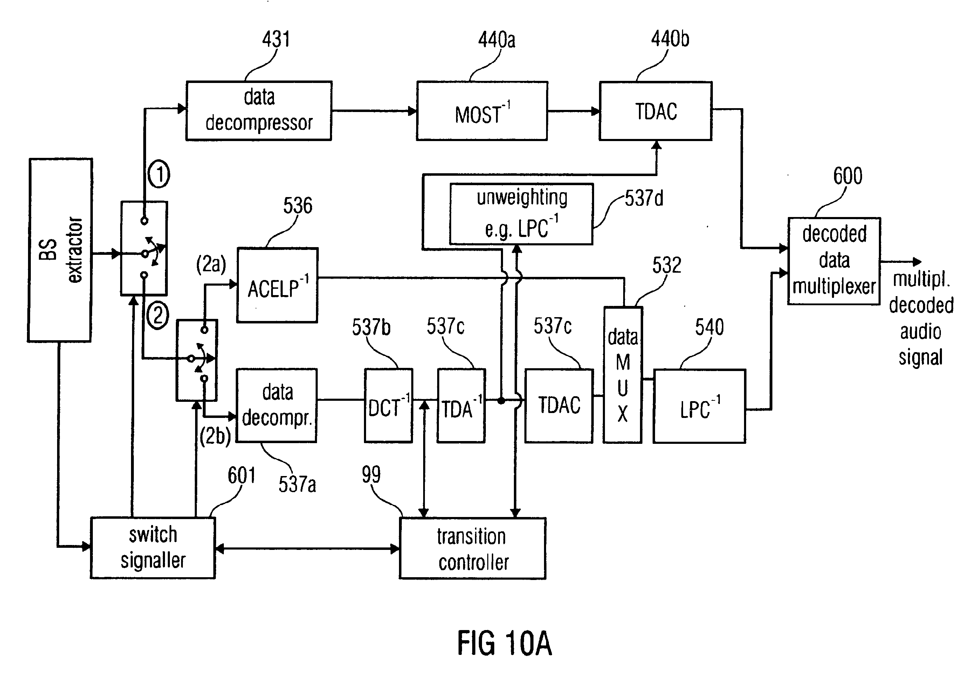

Feeding the aliasing portion subsequent to the DCT$^{-1}$ IV stage 86/stage 537b of Fig. 8B into the additional LPC$^{-1}$ stage 537d in Fig. 10A makes sure that a transform from the second domain to the first domain is performed, and, subsequently, the unfolding operation 87 and the windowing operation 88 of Fig. 8B are performed in block 537c. Therefore, the transition controller 99 receives data from block 537b subsequent to the DCT$^{-1}$ operation of stage 86, and then feeds this data to the LPC$^{-1}$ block 537d. The output of this procedure is then fed into block 537d to perform unfolding 87 and windowing 88. Then, the result of windowing the aliasing portion is forwarded to TDAC block 440b in order to perform an overlap-add operation with the corresponding aliasing portion of an AAC-MDCT block. In view of that, the order of processing for the aliasing block is: data decompression in 537a, DCT$^{-1}$ in 537b, inverse LPC and inverse TCX perceptual weighting (together meaning inverse weighting) in 537d, TDA$^{-1}$ processing in 537c and, then, overlap and add in 440b.

Nevertheless, the remaining portion of the frame is fed into the windowing stage before TDAC and inverse filtering/weighting in 540 as discussed in connection with Fig. 6 and as illustrated by the normal signal flow illustrated in Fig. 10A, when the arrows connected to block 99 are ignored.

In view of that, step 99c results the decoded audio signal for the aliasing portion subsequent to the TDAC 440b, and step 99d results in the decoded audio signal for the remaining/further portion subsequent to the TDAC 537c in the LPC domain and the inverse weighting in block 540.

Depending on certain implementation requirements, embodiments of the invention can be implemented in hardware or in software. The implementation can be performed using a digital storage medium, for example a floppy disk, a DVD, a CD, a ROM, a PROM, an EPROM, an EEPROM or a FLASH memory, having electronically readable control signals stored thereon, which cooperate (or are capable of cooperating) with a programmable computer system such that the respective method is performed.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other examples comprise the computer program for performing one of the methods described herein, stored on a machine readable carrier.

In other words, an embodiment of the inventive method is, therefore, a computer program having a program code for performing one of the methods described herein, when the computer program runs on a computer.

A further example of the inventive methods is, therefore, a data carrier (or a digital storage medium, or a computer-readable medium) comprising, recorded thereon, the computer program for performing one of the methods described herein.

A further example of the inventive method is, therefore, a data stream or a sequence of signals representing the computer program for performing one of the methods described herein. The data stream or the sequence of signals may for example be configured to be transferred via a data communication connection, for example via the Internet.

A further example comprises a processing means, for example a computer, or a programmable logic device, configured to or adapted to perform one of the methods described herein. AI

A further example comprises a computer having installed thereon the computer program for performing one of the methods described herein.

In some examples a programmable logic device (for example a field programmable gate array) may be used to perform some or all of the functionalities of the methods described herein. In some embodiments, a field programmable gate array may cooperate with a microprocessor in order to perform one of the methods described herein.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

**Claims**

1. Apparatus for encoding an audio signal, comprising:

   a windower (11) for windowing a first block of the audio signal using an analysis window, the analysis window having an aliasing portion ($L_k$, $R_k$), and a further portion ($M_k$);
   a processor (12) for processing a first sub-block (20) of the audio signal associated with the aliasing portion by transforming the first sub-block into a domain different from the domain, in which the audio signal is, subsequent to windowing the first sub-block to obtain a processed first sub-block, and for processing a second sub-block (21) of the audio signal associated with the further portion by transforming the second sub-block into the different domain before windowing the second sub-block to obtain a processed second sub-block; and
   a transformer (13) for converting the processed first sub-block and the processed second sub-block from the different domain into a further domain using the same block transform rule to obtain a converted first block,
wherein the apparatus is configured for further processing (14) the converted first block using a data compression algorithm.

2. Apparatus in accordance with claim 1, which is configured for processing a second block of the audio signal overlapping with the first block using a second analysis window (73) having an aliasing portion (73b) corresponding to the aliasing portion (72b) of the first analysis window.

3. Apparatus in accordance with claim 1 or claim 2, in which the domain, in which the audio signal is positioned, is a time domain, in which the different domain is an LPC domain, in which a third domain, in which a second block of the audio signal overlapping with the first block of the audio signal is encoded, is a frequency domain, and in which the further domain, in which the transformer (13) is configured for transforming, is an LPC frequency domain, and wherein the processor (12) comprises an LPC filter for transforming from the first domain to the second domain, or wherein the transformer (13) comprises a Fourier-based conversion algorithm for transforming input data into a frequency domain of the input data such as a DCT, a DST, an FFT, or a DFT.

4. Apparatus in accordance with one of the preceding claims, in which the windower (11) comprises a folding function (82) for folding input values to obtain output values, the number of output values being smaller than the number of input values, wherein the folding function is such that time aliasing is introduced into the output values.

5. Apparatus in accordance with any one of the preceding claims, in which the windower (11) is operative to perform the windowing to obtain the input values for a subsequently performed folding function (82).

6. Apparatus in accordance with one of the preceding claims, in which the apparatus comprises a first encoding branch (400) for encoding the audio signal in a frequency domain, and a second encoding branch (500) for encoding the audio signal based on a different frequency domain,
wherein the second encoding branch has a first sub-branch (527,528) for encoding the audio signal in the other frequency domain, and a second sub-branch (526) for encoding the audio signal in the other domain, the apparatus further comprising a decision stage (300) for deciding, whether a block of audio data is represented in an output bit stream by data generated using the first encoding branch or the first sub-branch or the second sub-branch of the second encoding branch, and

wherein the controller (98) is configured for controlling the decision stage (300) to decide in favor of the first sub-branch, when the transition from the first encoding branch to the second encoding branch or from the second encoding branch to the first encoding branch is to be performed.

7. Apparatus in accordance with any one of the preceding claims, in which the further portion comprises a non-aliasing portion ($M_k$) and an additional aliasing portion or an aliasing portion overlapping with a corresponding aliasing portion of a neighboring block of the audio signal.

8. Apparatus for decoding an encoded audio signal having an encoded first block of audio data, the encoded block having an aliasing portion and a further portion, comprising:

a processor (51) for processing the aliasing portion ($L_k$, $R_k$) by transforming (86) the aliasing portion into a target domain before performing a synthesis windowing (88) to obtain a windowed aliasing portion, and for performing a synthesis windowing (88) of the further portion before performing a transform (98) into the target domain; and

a time domain aliasing canceller (53) for combining the windowed aliasing portion and the windowed aliasing portion of an encoded second block of audio data subsequent to a transform (91) of the aliasing portion of the encoded first block of audio data into the target domain to obtain a decoded audio signal corresponding to the aliasing portion of the first block.

9. Apparatus in accordance with claim 8, in which the processor (51) comprises a transformer (86) for converting the aliasing portion from a fourth domain into a second domain, and wherein the processor furthermore comprises a transformer (91) for converting the aliasing portion represented in the second domain into the first domain, wherein the transformer (86) is operative to perform a block-based frequency time conversion algorithm.

10. Apparatus in accordance with claim 8 or 9, in which the processor (12) is operative to perform an unfolding operation (87) for obtaining output data having a number of values larger than a number of values input into the unfolding operation (87).

11. Apparatus in accordance with any one of claims 8,9, or 10, in which the processor (12) is operative to use a synthesis windowing function (88) being related to an analysis window function used when generating the encoded audio signal.

12. Apparatus in accordance with any one of claims 8 - 11, in which the encoded audio signal comprises a coding mode indicator indicating a coding mode for the encoded first block and the encoded second block, wherein the apparatus further comprises a transition controller (99) for controlling the processor (12), when the coding mode indicator indicates a coding mode change from a first coding mode to a different second coding mode or vice versa, and for controlling the processor (12) to perform the same operating for a complete encoding block, when a coding mode change between two encoding blocks is not signaled.

13. Apparatus in accordance with any one of claims 8 - 12,

in which a first coding mode and a second coding mode comprise an entropy decoding stage, a dequantizing stage, a frequency-time converting stage comprising an unfolding operation, and a synthesis windowing stage,

in which the time domain aliasing canceller (53) comprises an adder (89a) for adding corresponding aliasing portions of encoded blocks obtained by the synthesis windowing stage (88), the corresponding aliasing portions being obtained by an overlapping processing (89b) of the audio signal, and

in which, in the first coding mode, the time domain aliasing canceller (53) is configured for adding portions of blocks obtained by the synthesis windowing to obtain, as an output of the addition (89a), the decoded signal in the target domain, and

in which, in the second coding mode, the output of the addition (89a) is processed by the processor (12) to perform a transform (91) of the output of the addition to the target domain.

14. Encoded audio signal comprising an encoded first block of an audio signal and an overlapping encoded second block of the audio signal, the encoded first block of the audio signal comprising an aliasing portion and a further portion, the aliasing portion having been transformed from a first domain to a second domain subsequent to windowing (80) the aliasing portion, and the further portion having been transformed from the first domain into the second domain before windowing (80) the second sub-block, wherein the second sub-block has been transformed into a fourth domain using the same block transform rule, and

wherein the encoded second block has been generated by windowing (80) an overlapping block of audio samples and by transforming a windowed block into a third domain, wherein the encoded second block has an aliasing portion corresponding to the aliasing portion of the encoded first block of audio samples.

**15.** Method of encoding an audio signal, comprising:

windowing (11) a first block of the audio signal using an analysis window, the analysis window having an aliasing portion ($L_k,R_k$), and a further portion ($M_k$);

processing (12) a first sub-block (20) of the audio signal associated with the aliasing portion by transforming the first sub-block into a domain different from the domain, in which the audio signal is, subsequent to windowing the first sub-block to obtain a processed first sub-block;

processing a second sub-block (21) of the audio signal associated with the further portion by transforming the second sub-block into the different domain before windowing the second sub-block to obtain a processed second sub-block;

converting (13) the processed first sub-block and the processed second sub-block from the different domain into a further domain using the same block transform rule to obtain a converted first block; and

further processing (14) the converted first block using a data compression algorithm.

**16.** Method of decoding an encoded audio signal having an encoded first block of audio data, the encoded block having an aliasing portion and a further portion, comprising:

processing (51) the aliasing portion ($L_k,R_k$) by transforming (86) the aliasing portion into a target domain before performing a synthesis windowing (88) to obtain a windowed aliasing portion;

a synthesis windowing (88) of the further portion before performing a transform (98) into the target domain; and

combining (53) the windowed aliasing portion and the windowed aliasing portion of an encoded second block of audio data to obtain a time-domain aliasing cancellation, subsequent to a transform (91) of the aliasing portion of the encoded first block of audio data into the target domain to obtain a decoded audio signal corresponding to the aliasing portion of the first block.

**17.** Computer program product having a program code for performing, when running on a computer, the method for encoding in accordance with claim 15 or the method of decoding in accordance with claim 16.

**Patentansprüche**

**1.** Vorrichtung zum Codieren eines Audiosignals, die folgende Merkmale aufweist:

eine Fensterungseinrichtung (11) zum Fenstern eines ersten Blocks des Audiosignals unter Verwendung eines Analysefensters, wobei das Analysefenster einen Aliasing-Abschnitt ($L_k$, $R_k$) und einen weiteren Abschnitt ($M_k$) aufweist; einen Prozessor (12) zum Verarbeiten eines ersten Teilblocks (20) des Audiosignals, der dem Aliasing-Abschnitt zugeordnet ist, durch Transformieren des ersten Teilblocks in einen Bereich, der sich von dem Bereich unterscheidet, in dem das Audiosignal ist, nachfolgend zu dem Fenstern des ersten Teilblocks, um einen verarbeiteten ersten Teilblock zu erhalten, und zum Verarbeiten eines zweiten Teilblocks (21) des Audiosignals, der dem weiteren Abschnitt zugeordnet ist, durch Transformieren des zweiten Teilblocks in den unterschiedlichen Bereich vor dem Fenstern des zweiten Teilblocks, um einen verarbeiteten zweiten Teilblock zu erhalten; und einen Transformator (13) zum Umwandeln des verarbeiteten ersten Teilblocks und des verarbeiteten zweiten Teilblocks aus dem unterschiedlichen Bereich in einen weiteren Bereich unter Verwendung derselben Blocktransformationsregel, um einen umgewandelten, ersten Block zu erhalten,

wobei die Vorrichtung zum weiteren Verarbeiten (14) des umgewandelten ersten Blocks unter Verwendung eines Datenkompressionsalgorithmus ausgebildet ist.

**2.** Vorrichtung gemäß Anspruch 1, die ausgebildet ist zum Verarbeiten eines zweiten Blocks des Audiosignals, der den ersten Block überlappt, unter Verwendung eines zweiten Analysefensters (73) mit einem Aliasing-Abschnitt (73b), der dem Aliasing-Abschnitt (72b) des ersten Analysefensters entspricht.

**3.** Vorrichtung gemäß Anspruch 1 oder Anspruch 2, bei der der Bereich, in dem das Audiosignal positioniert ist, ein Zeitbereich ist, bei der der unterschiedliche Bereich ein LPC-Bereich ist, bei der ein dritter Bereich, in dem ein zweiter Block des Audiosignals, der den ersten Block des Audiosignals überlappt, codiert ist, ein Frequenzbereich ist, und bei der der weitere Bereich, in dem der Transformator (13) zum Transformieren ausgebildet ist, ein LPC-Frequenzbereich ist, und

wobei der Prozessor (12) ein LPC-Filter aufweist zum Transformieren aus dem ersten Bereich in den zweiten Bereich, oder bei dem der Transformator (13) einen Fourier-basierten Umwandlungsalgorithmus aufweist zum Transformieren von Eingangsdaten in einen Frequenzbereich der Eingangsdaten, wie zum Beispiel eine DCT, eine DST, eine FFT oder eine DFT.

**4.** Vorrichtung gemäß einem der vorangehenden Ansprüche, bei der die Fensterungseinrichtung (11) eine Faltfunktion (82) aufweist zum Falten von Eingangswerten, um Ausgangswerte zu erhalten, wobei die Anzahl der Ausgangswerte kleiner ist als die Anzahl der Eingangswerte, wobei die Faltfunktion derart ist, dass ein Zeit-Aliasing in die Ausgangswerte eingebracht wird.

5. Vorrichtung gemäß einem der vorangehenden Ansprüche, bei der die Fensterungseinrichtung (11) wirksam ist, das Fenstern auszuführen, um die Eingangswerte für eine nachfolgend ausgeführte Faltfunktion (82) zu erhalten.

6. Vorrichtung gemäß einem der vorangehenden Ansprüche, wobei die Vorrichtung einen ersten Codierzweig (400) aufweist zum Codieren des Audiosignals in einem Frequenzbereich und einem zweiten Codierzweig (500) zum Codieren des Audiosignals basierend auf einem unterschiedlichen Frequenzbereich,
wobei der zweite Codierzweig einen ersten Teilzweig (527, 528) aufweist zum Codieren des Audiosignals in dem anderen Frequenzbereich, und einen zweiten Teilzweig (526) zum Codieren des Audiosignals in dem anderen Bereich, wobei die Vorrichtung ferner eine Entscheidungsstufe (300) aufweist zum Entscheiden, ob ein Block aus Audiodaten in einem Ausgangsbitstrom dargestellt ist durch Daten, die unter Verwendung des ersten Codierzweigs oder des ersten Teilzweigs oder des zweiten Teilzweigs des zweiten Codierzweigs erzeugt werden, und wobei die Steuerung (98) ausgebildet ist zum Steuern der Entscheidungsstufe (300), um für den ersten Teilzweig zu entscheiden, wenn der Übergang von dem ersten Codierzweig zu dem zweiten Codierzweig oder von dem zweiten Codierzweig zu dem ersten Codierzweig ausgeführt werden soll.

7. Vorrichtung gemäß einem der vorangehenden Ansprüche, bei der der weitere Abschnitt einen Nicht-Aliasing-Abschnitt ($M_k$) und einen zusätzlichen Aliasing-Abschnitt aufweist oder einen Aliasing-Abschnitt, der einen entsprechenden Aliasing-Abschnitt eines benachbarten Blocks des Audiosignals überlappt.

8. Vorrichtung zum Decodieren eines codierten Audiosignals mit einem codierten ersten Block aus Audiodaten, wobei der codierte Block einen Aliasing-Abschnitt und einen weiteren Abschnitt aufweist, die folgende Merkmale aufweist:

einen Prozessor (51) zum Verarbeiten des Aliasing-Abschnitts ($L_k$, $R_k$) durch Transformieren (86) des Aliasing-Abschnitts in einen Zielbereich vor dem Ausführen einer Synthese-Fensterung (88), um einen gefensterten Aliasing-Abschnitt zu erhalten, und zum Ausführen einer Synthese-Fensterung (88) des weiteren Abschnitts vor dem Ausführen einer Transformation (98) in den Zielbereich; und
einen Zeitbereichs-Aliasing-Löscher (53) zum Kombinieren des gefensterten Aliasing-Abschnitts und des gefensterten Aliasing-Abschnitts eines codierten zweiten Blocks aus Audiodaten nachfolgend zu einer Transformation (91) des Aliasing-Abschnitts des codierten ersten Blocks aus Audiodaten in den Zielbereich, um ein decodiertes Audiosignal zu erhalten, das dem Aliasing-Abschnitt des ersten Blocks entspricht.

9. Vorrichtung gemäß Anspruch 8,
bei der der Prozessor (51) einen Transformator (86) aufweist zum Umwandeln des Aliasing-Abschnitts aus einem vierten Bereich in einem zweiten Bereich, und bei dem der Prozessor ferner einen Transformator (91) aufweist zum Umwandeln des Aliasing-Abschnitts, dargestellt in dem zweiten Bereich, in den ersten Bereich, wobei der Transformator (86) wirksam ist, einen Block-basierten Frequenz-Zeit-Umwandlungsalgorithmus auszuführen.

10. Vorrichtung gemäß Anspruch 8 oder 9, bei der der Prozessor (12) wirksam ist, eine Entfaltungsoperation (87) auszuführen zum Erhalten von Ausgangsdaten mit einer Anzahl von Werten, die größer ist als eine Anzahl von Werten, die in die Entfaltungsoperation (87) eingegeben werden.

11. Vorrichtung gemäß einem der Ansprüche 8, 9 oder 10, bei der der Prozessor (12) wirksam ist, eine Synthesefensterungsfunktion (88) zu verwenden, die sich auf eine Analysefensterfunktion bezieht, die beim Erzeugen des codierten Audiosignals verwendet wird.

12. Vorrichtung gemäß einem der Ansprüche 8 bis 11, bei der das codierte Audiosignal einen Codiermodusindikator aufweist, der einen Codiermodus anzeigt für den codierten ersten Block und den codierten zweiten Block,
wobei die Vorrichtung ferner eine Übergangssteuerung (99) aufweist zum Steuern des Prozessors (12), wenn der Codiermodusindikator eine Codiermodusänderung von einem ersten Codiermodus in einen unterschiedlichen zweiten Codiermodus anzeigt oder umgekehrt, und zum Steuern des Prozessors (12), um dieselbe Operation für einen kompletten Codierblock auszuführen, wenn eine Codiermodusänderung zwischen zwei Codierblöcken nicht signalisiert wird.

13. Vorrichtung gemäß einem der Ansprüche 8 bis 12, bei der ein erster Codiermodus und ein zweiter Codiermodus eine Entropie-Decodierstufe, eine Dequantisierungsstufe, eine Frequenz-Zeit-Umwandlungsstufe, die eine Entfaltungsoperation aufweist, und eine Synthesefensterungsstufe aufweisen, bei der der Zeitbereichs-Aliasing-Löscher (53) einen Addierer (89a) aufweist zum Addieren entsprechender Aliasing-Abschnitte codierter Blöcke, die durch die Synthese-Fensterungsstufe (88) erhalten werden, wobei die entsprechenden Aliasing-Abschnitte durch eine überlappende Verarbeitung (89b) des Audiosignals erhalten werden, und bei der, in dem ersten Codiermodus, der Zeitbereichs-Aliasing-Löscher (53) ausgebildet ist zum Addieren von Abschnitten von Blöcken, die durch die Synthesefensterung erhalten werden, um als eine Ausgabe der Addition (89a) das decodierte Signal in dem Zielbereich zu erhalten, und bei der in dem zweiten Codiermodus die Ausgabe der Addition (89a) durch den Prozessor (12) verarbeitet wird, um eine Transformation (91) der Ausgabe der Addition zu dem Zeitbereich auszuführen.

14. Codiertes Audiosignal, das einen codierten ersten Block eines Audiosignals und einen überlappenden, codierten zweiten Block des Audiosignals aufweist, wobei der codierte erste Block des Audiosignals einen Aliasing-Abschnitt und einen weiteren Abschnitt aufweist, wobei der Aliasing-Abschnitt von einem ersten Bereich zu einem zweiten Bereich transformiert wurde, nachfolgend zu den Fenstern (80) des Aliasing-Abschnitts, und der weitere Abschnitt von dem ersten Bereich in den zweiten Bereich transformiert wurde, vor dem Fenstern (80) des zweiten Teilblocks, wobei der zweite Teilblock in einen vierten Bereich transformiert wurde unter Verwendung derselben Blocktransformationsregel, und wobei der codierte zweite Block durch Fenstern (80) eines überlappenden Blocks aus Audioabtastwerten erzeugt wurde und durch Transformieren eines gefensterten Blocks in einen dritten Bereich, wobei der codierte, zweite Block einen Aliasing-Abschnitt aufweist, der dem Aliasing-Abschnitt des codierten, ersten Blocks aus Audioabtastwerten entspricht.

15. Verfahren zum Codieren eines Audiosignals, das folgende Schritte aufweist:

Fenstern (11) eines ersten Blocks des Audiosignals unter Verwendung eines Analysefensters, wobei das Analysefenster einen Aliasing-Abschnitt ($L_k$, $R_k$) und einen weiteren Abschnitt ($M_k$) aufweist;
Verarbeiten (12) eines ersten Teilblocks (20) des Audiosignals, zugeordnet zu dem Aliasing-Abschnitt, durch Transformieren des ersten Teilblocks in einen Bereich, der sich von dem Bereich unterscheidet, in dem das Audiosignal ist, nachfolgend zu dem Fenstern des ersten Teilblocks, um einen verarbeiteten, ersten Teilblock zu erhalten;
Verarbeiten eines zweiten Teilblocks (21) des Audiosignals, zugeordnet zu dem weiteren Abschnitt, durch Transformieren des zweiten Teilblocks in den unterschiedlichen Bereich vor dem Fenstern des zweiten Teilblocks, um einen verarbeiteten, zweiten Teilblock zu erhalten;
Umwandeln (13) des verarbeiteten, ersten Teilblocks und des verarbeiteten, zweiten Teilblocks aus dem unterschiedlichen Bereich in einen weiteren Bereich unter Verwendung derselben Blocktransformationsregel, um einen umgewandelten, ersten Block zu erhalten; und
weiteres Verarbeiten (14) des umgewandelten, ersten Blocks unter Verwendung eines Datenkompressionsalgorithmus.

16. Verfahren zum Decodieren eines codierten Audiosignals mit einem codierten ersten Block aus Audiodaten, wobei der codierte Block einen Aliasing-Abschnitt und einen weiteren Abschnitt aufweist, das folgende Schritte aufweist:

Verarbeiten (51) des Aliasing-Abschnitts ($L_k$, $R_k$) durch Transformieren (86) des Aliasing-Abschnitts in einen Zielbereich vor dem Ausführen einer Synthesefensterung (88), um einen gefensterten Aliasing-Abschnitt zu erhalten;
ein Synthese-Fenstern (88) des weiteren Abschnitts vor dem Ausführen einer Transformation (98) in den Zielbereich; und
Kombinieren (53) des gefensterten Aliasing-Abschnitts und des gefensterten Aliasing-Abschnitts eines codierten zweiten Blocks aus Audiodaten, um eine Zeitbereichs-Aliasing-Löschung zu erhalten, nachfolgend zu einer Transformation (91) des Aliasing-Abschnitts des codierten ersten Blocks aus Audiodaten in den Zielbereich, um ein decodiertes Audiosignal zu erhalten, das dem Aliasing-Abschnitt des ersten Blocks entspricht.

17. Computerprogrammprodukt mit einem Programmcode zum Ausführen, wenn es auf einem Computer ausgeführt wird, des Verfahrens zum Codieren gemäß Anspruch 15 oder des Verfahrens zum Codieren gemäß Anspruch 16.

**Revendications**

1. Appareil pour coder un signal audio, comprenant:

un diviseur en fenêtres (11) destiné à diviser en fenêtres un premier bloc du signal audio à l'aide d'une fenêtre d'analyse, la fenêtre d'analyse présentant une partie de repliement ($L_k$, $R_k$), et une autre partie ($M_k$);

un processeur (12) destiné à traiter un premier sous-bloc (20) du signal audio associé à la partie de repliement en transformant le premier sous-bloc en un domaine différent du domaine dans lequel se trouve le signal audio à la suite de la division en fenêtres du premier sous-bloc, pour obtenir un premier sous-bloc traité, et à traiter un deuxième sous-bloc (21) du signal audio associé à l'autre partie en transformant le deuxième sous-bloc au domaine différent avant de diviser en fenêtres le deuxième sous-bloc, pour obtenir un deuxième sous-bloc traité; et

un transformateur (13) destiné à convertir le premier sous-bloc traité et le deuxième sous-bloc traité du domaine différent en un autre domaine à l'aide de la même règle de transformation de bloc, pour obtenir un premier bloc converti, dans lequel l'appareil est configuré pour traiter davantage (14) le premier bloc converti à l'aide d'un algorithme de compression de données.

2. Appareil selon la revendication 1, qui est configuré pour traiter un deuxième bloc du signal audio en recouvrement avec le premier bloc à l'aide d'une deuxième fenêtre d'analyse (73) présentant une partie de repliement (73b) correspondant à la partie de repliement (72b) de la première fenêtre d'analyse.

3. Appareil selon la revendication 1 ou la revendication 2, dans lequel le domaine dans lequel est positionné le signal audio est un domaine temporel, dans lequel le domaine différent est un domaine LPC, dans lequel un troisième domaine dans lequel est codé un deuxième bloc du signal audio en recouvrement avec le premier bloc du signal audio est un domaine fréquentiel, et dans lequel l'autre domaine dans lequel le transformateur (13) est configuré pour transformer est un domaine fréquentiel LPC, et dans lequel le processeur (12) comprend un filtre LPC destiné à transformer du premier domaine au deuxième domaine, ou dans lequel le transformateur (13) comprend un algorithme de conversion à base de Fourier destiné à transformer les données d'entrée au domaine fréquentiel des données d'entrée, tel qu'une DCT, une DST, une FFT ou une DFT.

4. Appareil selon l'une des revendications précédentes, dans lequel le diviseur en fenêtres (11) comprend une fonction de pliage (82) pour plier les valeurs d'entrée, pour obtenir des valeurs de sortie, le nombre de valeurs de sortie étant inférieur au nombre de valeurs d'entrée, dans lequel la fonction de pliage est telle que le repliement temporel est introduit dans les valeurs de sortie.

5. Appareil selon l'une quelconque des revendications précédentes, dans lequel le diviseur en fenêtres (11) est opérationnel pour réaliser la division en fenêtres pour obtenir les valeurs d'entrée pour une fonction de pliage (82) réalisée successivement.

6. Appareil selon l'une quelconque des revendications précédentes, dans lequel l'appareil comprend une première branche de codage (400) pour coder le signal audio au domaine fréquentiel, et une deuxième branche de codage (500) pour coder le signal audio sur base d'un domaine fréquentiel différent, dans lequel la deuxième branche de codage présente une première sous-branche (527, 528) destinée à coder le signal audio dans l'autre domaine fréquentiel, et une deuxième sous-branche (526) destinée à coder le signal audio dans l'autre domaine, l'appareil comprenant par ailleurs un étage de décision (300) destiné à décider si un bloc de données audio est représenté dans un flux de bits de sortie par les données générées à l'aide de la première branche de codage ou de la première sous-branche ou de la deuxième sous-branche de la deuxième branche de codage, et

dans lequel le contrôleur (98) est configuré pour commander l'étage de décision (300) pour décider en faveur de la première sous-branche lorsque la transition de la première branche de codage à la deuxième branche de codage ou de la deuxième branche de codage à la première branche de codage doit être réalisée.

7. Appareil selon l'une quelconque des revendications précédentes, dans lequel l'autre partie comprend une partie non de repliement ($M_k$) et une partie de repliement additionnelle ou une partie de repliement venant en recouvrement avec une partie de recouvrement correspondante d'un bloc voisin du signal audio.

8. Appareil de décodage d'un signal audio codé présentant un premier bloc codé de données audio, le bloc codé présentant une partie de repliement et une autre partie, comprenant:

un processeur (51) destiné à traiter la partie de repliement ($L_k$, $R_k$) en transformant (86) la partie de repliement au domaine cible avant de réaliser une division en fenêtres de synthèse (88), pour obtenir une partie de repliement divisée en fenêtres, et à effectuer une division en fenêtres de synthèse (88) de l'autre partie avant de réaliser une transformée (98) au domaine cible; et

un annuleur de repliement dans le domaine temporel (53) destiné à combiner la partie de repliement divisée en fenêtres et la partie de repliement divisée en fenêtres d'un deuxième bloc de données audio codé successif, pour obtenir une transformée (91) de la partie de repliement du premier bloc de données audio codé au domaine cible, pour obtenir un signal audio décodé correspondant à la partie de repliement du premier bloc.

9. Appareil selon la revendication 8,
dans lequel le processeur (51) comprend un transformateur (86) destiné à convertir la partie de repliement d'un quatrième domaine au deuxième domaine, et dans lequel le processeur comprend par ailleurs un transformateur (91) destiné à convertir la partie de repliement représentée dans le deuxième domaine au premier domaine, dans lequel le transformateur (86) est opérationnel pour réaliser un algorithme de conversion fréquence-temps à base de blocs.

10. Appareil selon la revendication 8 ou 9, dans lequel le processeur (12) est opérationnel pour réaliser une opération de dépliement (87), pour obtenir des données de sortie ayant un nombre de valeurs supérieur à un nombre de valeurs entrées dans l'opération de dépliement (87).

11. Appareil selon l'une quelconque des revendications 8, 9 ou 10, dans lequel le processeur (12) est opérationnel pour utiliser une fonction de division en fenêtres de synthèse (88) qui est en rapport avec une fonction de fenêtre d'analyse utilisée pour générer le signal audio codé.

12. Appareil selon l'une quelconque des revendications 8 à 11, dans lequel le signal audio codé comprend un indicateur de mode de codage indiquant un mode de codage pour le premier bloc codé et le deuxième bloc codé,
dans lequel l'appareil comprend par ailleurs un contrôleur de transition (99) destiné à commander le processeur (12) lorsque l'indicateur de mode de codage indique un changement de mode de codage d'un premier mode de codage à un deuxième mode de codage différent, ou inversement, et à commander le processeur (12) pour effectuer la même opération pour un bloc de codage complet lorsqu'un changement de mode de codage entre deux blocs de codage n'est pas signalé.

13. Appareil selon l'une quelconque des revendications 8 à 12,
dans lequel un premier mode de codage et un deuxième mode de codage comprend un étage de décodage entropique, un étage de déquantification, un étage de conversion fréquence-temps comprenant une opération de dépliement, et un étage de division en fenêtres de synthèse,
dans lequel l'annuleur de repliement dans le domaine temporel (53) comprend un additionneur (89a) destiné à additionner les parties de repliement correspondantes des blocs codés obtenus par l'étage de division en fenêtres de synthèse (88), les parties de repliement correspondantes étant obtenues par un traitement de recouvrement (89b) du signal audio, et
dans lequel, dans le premier mode de codage, l'annuleur de repliement dans le domaine temporel (53) est configuré pour additionner les parties des blocs obtenus par la division en fenêtres de synthèse, pour obtenir, comme sortie de l'addition (89a), le signal décodé dans le domaine cible, et
dans lequel, dans le deuxième mode de codage, la sortie de l'addition (89a) est traitée par le processeur (12) pour réaliser une transformée (91) de la sortie de l'addition au domaine cible.

14. Signal audio codé comprenant un premier bloc codé d'un signal audio et un deuxième bloc codé du signal audio venant en recouvrement, le premier bloc codé du signal audio, comprenant une partie à repliement et une autre partie, la partie à repliement ayant été transformée d'un premier domaine à un deuxième domaine à la suite de la division en fenêtres (80) de la partie à repliement, et l'autre partie ayant été transformée du premier domaine au deuxième domaine avant la division en fenêtres (80) du deuxième sous-bloc, ou le deuxième sous-bloc a été transformé à un quatrième domaine à l'aide de la même règle de transformation de bloc, et
dans lequel le deuxième bloc codé a été généré en divisant en fenêtres (80) un bloc en recouvrement d'échantillons audio et en transformant un bloc divisé en fenêtres au troisième domaine, où le deuxième bloc codé présente une partie à repliement correspondant à la partie à repliement du premier bloc codé d'échantillons audio.

15. Procédé de codage d'un signal audio, comprenant:

diviser en fenêtres (11) un premier bloc du signal audio à l'aide d'une fenêtre d'analyse, la fenêtre d'analyse présentant une partie à repliement ($L_k$, $R_k$), et une autre partie ($M_k$);
traiter (12) un premier sous-bloc (20) du signal audio associé à la partie à repliement en transformant le premier sous-bloc à un domaine différent du domaine dans lequel se trouve le signal audio après la division en fenêtres du premier sous-bloc, pour obtenir un premier sousbloc traité;
traiter un deuxième sous-bloc (21) du signal audio associé à l'autre partie en transformant le deuxième sous-bloc au domaine différent avant la division en fenêtre du deuxième sous-bloc, pour obtenir un deuxième sous-bloc traité;
convertir (13) le premier sous-bloc traité et le deuxième sous-bloc traité du domaine différent à un autre domaine à l'aide de la même règle de transformation de bloc, pour obtenir un premier bloc converti; et
traiter davantage (14) le premier bloc converti à l'aide d'un algorithme de compression de données.

16. Procédé de décodage d'un signal audio codé présentant un premier bloc de données audio codé, le bloc codé présentant une partie à repliement et une autre partie, comprenant:

traiter (51) la partie à repliement ($L_k$, $R_k$) en transformant (86) la partie à repliement au domaine cible avant de réaliser une division en fenêtres de synthèse (88), pour obtenir une partie à repliement divisée en fenêtres;
une division en fenêtres de synthèse (88) de l'autre partie avant de réaliser une transformée (98) au domaine cible; et
combiner (53) la partie à repliement divisée en fenêtres et la partie à repliement divisée en fenêtres d'un deuxième bloc de données audio codé, pour obtenir une annulation de repliement dans le domaine temporel, à la suite d'une transformée (91) de la partie à repliement du premier bloc de données audio codé au domaine cible, pour obtenir un signal audio décodé correspondant à la partie à repliement du premier bloc.

17. Programme d'ordinateur ayant un code de programme pour réaliser, lorsqu'il est exécuté sur un ordinateur, le procédé de codage selon la revendication 15 ou le procédé de décodage selon la revendication 16.

FIG 1A
(encoder side)

EP 2 301 020 B1

**FIG 1B**

MDCT-TCX → AAC

22  21  first block

first sub-block

MDCT-TCX | aliasing portion | non-aliasing portion | aliasing portion | 20

corresp. aliasing portion

t

AAC

second sub-block

23  24  second block

**FIG 1C**

first block  21

AAC → MDCT-TCX

first sub-block

MDCT-TCX

20  aliasing portion | non-aliasing portion | 22

corresp. aliasing portion

second sub-block

t

AAC

second block  24  23

audio signal (stream)

block forming — 30

second sub-block
(further portion)

first sub-block
(aliasing portion)

transforming
to second domain — 32

31b — windowing

windowing — 31a

transforming to
second domain — 33

— 34

one block input
to block transform

block transform to fourth domain — 35

36 — converted first block

further processing
(data compression) — 37

encoded first block

FIG 1D

EP 2 301 020 B1

third domain
(e.g. frequency
domain)

(e.g. AAC-MDCT)

42

e.g. time / frequency transform
(DCT, DST, FT, FFT,...)

fourth domain
(e.g. LPC
frequency domain)

(e.g. MDCT-TCX)

43

e.g. time / frequency transform
(DCT, DST, FT, FFT,...)

first domain
(e.g. time domain)

e.g. LPC
filter / transform

second domain
(e.g. LPC domain)

(e.g. ACELP)

40

41

FIG 2

encoded
first block

50

processor
- transforming before
  synthesis wind. or
- transforming subsequent
  to synthesis wind.

51

windowed
aliasing
portion

52

54

corresponding
windowed
aliasing
portion of
encoded
second block

time-domain
aliasing canceller
(e.g. overlap / add)

53

55

decoded audio
signal corresponding
to aliasing portion
of first block

# FIG 3A
## (decoder side)

decoder processing of encoded
first block

(e.g. fourth domain)

~56

frequency/time converting
of complete first block

~57

(e.g. second domain)

first sub-block
(aliasing portion)

second
sub-block

transforming
to target domain

~58a

59b~ windowing using
synthesis window

windowing using
synthesis win.

~59a

aliasing~

60a

portion of
other block

combining
with corresp. portion
of other block

combining
with corresp. portion
of second block

portion
of second block

60b

non-
aliasing

decoded audio signal
for first sub-block

transforming to
target domain

~58b

decoded audio
signal for second sub-block

## FIG 3B

FOLDING: $(-c_R-d,$

(2N input values $\qquad a - b_R)$ R: reverse operator

N output values)

UNFOLDING: $(a - b_R, b-a_R, c+d_R, d+c_R)\cdot\dfrac{1}{2}$

(N input values

2N output values) MDCT $\underbrace{(a,b,s,d)}_{\substack{\text{2N input} \\ \text{values}}} \equiv \text{DCT-IV}\underbrace{(-c_R-d, a-b_R)}_{\substack{\text{N input} \\ \text{values}}}$

$\underbrace{\text{IMDCT ( MDCT}(a,b,c,d))}_{\substack{\text{2N output} \\ \text{values}}} = (a-b_R, b-a_R, c+d_R, d+c_R)\cdot\dfrac{1}{2}$

# FIG 4A

FIG 4B

**FIG 5**

TCX-MDCT performs in the W(z) filtered domain

FIG 6

EP 2 301 020 B1

specific sequence of windowing for transitions between AAC and AMR-WB+

FIG 7

EP 2 301 020 B1

encoder

decoder

TCX-MDCT for the $R_k = 128$ last samples before a AAC segment

FIG 8A

encoder

$L_k$     $L_k/2$

92     83     84

| windowing | → | folding | → | W(z) | → | DCT IV | → | Q | →

TDA

80     82

decoder

91

$R_{k+1}=L_k$

← AAC-MDCT $R_{k-1}$

$L_k$     $L_k$

→ | $Q^{-1}$ | → | DCT$^{-1}$IV | → | W$^{-1}$(z) | → | unfolding | → | windowing | → | adding | →    $L_k$

ITDA

85     86     87     88     89a

TCX-MDCT for the $L_k=128$ first samples after a AAC segment

FIG 8B

FIG 9A

```
┌─────────────────────────┐
│   detect transition,    │───── 98a
│   bias switch to (2b)   │
└─────────────────────────┘
            │
            ▼
┌─────────────────────────┐
│   for data in aliasing  │
│  portion, do not feed in LPC, │
│  but perform TDA / LPC / DCT  │───── 98b
│   processing in this order    │
└─────────────────────────┘
            │
            ▼
┌─────────────────────────┐
│   for data in non-alias.  │
│   portion, feed in LPC and │───── 98c
│  then in weighting / MDCT  │
└─────────────────────────┘
            │
            ▼
┌─────────────────────────┐
│   perform common MDCT   │
│    operation and data   │───── 98d
│      compression        │
└─────────────────────────┘
```

# FIG 9B

FIG 10A

EP 2 301 020 B1

```
           ┌─────────────────────────┐
           │     detect transition   │────99a
           └─────────────────────────┘
                        │
                        ▼
           ┌─────────────────────────┐
           │     feed whole frame     │
           │   in DCT⁻¹ stage 537b    │────99b
           └─────────────────────────┘
                        │
                        ▼
           ┌─────────────────────────┐
   99c─────│    feed aliasing portion │
           │    in LPC⁻¹ stage 537d   │──────►  decoded audio
           │  before TDAC stage 537d  │         signal for aliasing
           └─────────────────────────┘          portion (subsequent to TDAC)
                        │
                        ▼
           ┌─────────────────────────┐
   99d─────│  feed remaining portion  │
           │ of frame in windowing stage │
           │ before TDAC and weighting │
           └─────────────────────────┘
                        │
                        ▼
                             decoded audio signal
                           for remaining / non - aliasing
                            portion subsequent to TDAC
                              and (inverse) weighting
```

# FIG 10B

40

FIG 11A

EP 2 301 020 B1

FIG 11B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008071353 A2

**Non-patent literature cited in the description**

- **J. PRINCEN ; A. BRADLEY.** Analysis/Synthesis Filter Bank Design Based on Time Domain Aliasing Cancellation. *IEEE Trans. ASSP, ASSP,* 1986, vol. 34 (5), 1153-1161
- Extended Adaptive Multi-Rate - Wideband (AMR-WB+) codec. *3GPP TS 26.290 V6.3.0,* June 2005

- **SEAN A. RAMPRASHAD.** The Multimode Transform predictive Coding Paradigm. *IEEE Transaction on Speech and Audio Processing,* March 2003, vol. 11 (2